# EUROPEAN PATENT SPECIFICATION

(11) **EP 0 909 118 B1**
(45) Date of publication and mention of the grant of the patent: **05.03.2008**
(21) Application number: 98307441.0
(22) Date of filing: 15.09.1998
(51) Int. Cl.: H05K 1/09, H05K 3/38, H05K 3/40, H05K 9/00

(54) **Conductive elastomer for grafting to an elastic substrate**
Leitfähiges Elastomer zur Pfropfung auf ein elastisches Substrat
Elastomère conducteur pour greffage à un substrat élastique

(30) Priority: 16.09.1997 US 931130; 16.09.1997 US 931142; 16.09.1997 US 931438
(43) Date of publication of application: 14.04.1999
(73) Proprietor: Thomas & Betts International, Inc., Sparks, Nevada 89434 (US)
(72) Inventor: Crotzer, David R., Nashua, New Hampshire 03060 (US); Michaud, Arthur G., New Bedford, Massachusetts 01460 (US); Hanrahan, Mark G., Little Common, Massachusetts 02740 (US); Silva, Neill N., Greenville, Rhode Island 02828 (US)
(74) Representative: Howick, Nicholas Keith

(56) References cited:
- GB-A- 1 565 207
- US-A- 3 767 519
- US-A- 3 818 415
- US-A- 3 971 610
- US-A- 4 680 139
- US-A- 4 908 740
- US-A- 5 527 591
- US-A- 5 600 099
- PATENT ABSTRACTS OF JAPAN vol. 014, no. 308 (E-0947), 3 July 1990 (1990-07-03) & JP 02 098191 A (FURUKAWA ELECTRIC CO), 10 April 1990 (1990-04-10)

## Description

### FIELD OF INVENTION

The present invention relates generally to electrically conductive devices and, more particularly, to an electrically conductive elastomer for grafting to elastic substrates, thermoplastic substrates, thermoset substrates and metal substrates.

### BACKGROUND OF THE INVENTION

The electronics industry has evolved to the point where electronic circuitry is present in a large number of new products. Many of these new products are used in environments where elastic properties are required, for example, to have a product fit into a confined or hard to reach area. Also, it is sometimes desirable to have electronic circuitry attached to a material having elastic properties.

United States patent 3,971,610 discloses electrical contacts and connectors which are made of resilient elastomers and which incorporate a carbon or metallic filler. The metallic filler may be made of silver and can be used in various configurations such as powder, fibres, chopped wire and flakes.

United States patent 5,600,099 discloses electrical devices formed of a conductive area or surface chemically grafted onto a substrate surface. The conductive material grafted to the substrate is composed of conductive particles, such as silver or other metal, each coated with a conductive or non-conductive polymer material. The particles are contained within a slurry and applied to the substrate surface.

It would be desirable to provide an improved electrically conductive material having elastic properties. More particularly, it would be desirable to provide an electrically conductive elastomer for grafting to an elastic substrate.

The electronic circuitry for most present day electronic products is typically provided on circuit boards. Most circuit boards are fabricated of thermoset materials such as, for example, FR4^{™}, which contains epoxy and glass fibers. It is because of these constituent elements that thermoset materials have rigid properties. Such rigid properties are required for many applications wherein electronic circuitry is utilized.

A circuit board typically has electrically conductive traces formed thereon for making electrical connections between electronic devices mounted on the circuit board. These electrically conductive traces are typically formed by an etching process wherein a copper alloy material is applied to a surface of the circuit board, and then portions of the copper alloy material is etched away, thereby leaving the remaining copper alloy material to act as the electrically conductive traces. This etching process is typically time and labor intensive. Also, the electrically conductive traces often break when the circuit board is flexed or becomes warped due to changing thermal and/or moisture conditions. Thus, it would be beneficial to provide a material which may be used to form electrically conductive traces on a circuit board that is easily applied and can flexibly withstand most environmental conditions.

Electronic circuitry can also be provided on flex film circuits. Such flex film circuits are typically fabricated of thermoplastic materials such as, for example, KAPTON^{™}, which contains resin fibers. These resin fibers give the flex film circuits their flexible qualities.

A flex film circuit is typically fabricated by laminating at least one electrically conductive copper alloy trace between two sheets of a thermoplastic film such as, for example, KAPTON^{™}. An adhesive is often used to insure that the two sheets of the film remain secured together. This lamination process involves several steps and requires precise alignment of the sheets of thermoplastic film and the electrically conductive copper alloy traces as there are typically openings in the sheets of thermoplastic film to allow access to the electrically conductive copper alloy traces. Also, it is often the case that the electrically conductive traces will fracture after repeated flexing of the flex film circuit. Thus, it would be beneficial to provide a material which may be used to form electrically conductive traces on a flex film circuit that is easily applied and can withstand repeated flexing of the flex film circuit.

A circuit board provides electrical interconnections between electronic components mounted on the circuit board. The electronic components have electrically conductive leads or terminals which are typically soldered to electrically conductive through-holes or contact pads, respectively, formed on the circuit board. The electrically conductive leads or terminals of an electronic component are part of the packaging of a semiconductor die which actually contains all of the electronic circuitry associated with the electronic component. The packaging of a semiconductor die includes making electrically conductive wire bond connections between electrically conductive contact points on the semiconductor die and electrically conductive leads or terminals of a ceramic, plastic, or some other type of package.

The need for packaging a semiconductor die is two-fold. First, the package of an electronic component is a heat sink for the semiconductor die contained within the package. Second, the package of an electronic component provides electrically conductive leads and terminals by which the electronic component may be secured to a circuit board.

A major shortcoming of a semiconductor die package is the circuit board area that the package requires. That is, the size of a semiconductor die package is often two or three times the size of the semiconductor die that is contained therein. The extra area that is consumed by the package could be used for more circuitry on the circuit board.

Another shortcoming of a semiconductor die package is the potential for failure or breakage of the electrically conductive wire bond connections between the electrically conductive contact points on the semiconductor die and the electrically conductive leads or terminals of the package. Furthermore, the electrically conductive wire bond connections and the electrically conductive leads or terminals of the package are susceptible to noise and induce propagation delays in signals travelling thereover.

Accordingly, it would be beneficial to provide a means by which a semiconductor die may make electrical connections with electrically conductive contact pads on a circuit board without requiring extensive packaging of the semiconductor die. More particularly, it would be beneficial to provide a material which may be used to make direct electrical connections between electrically conductive contact points on a semiconductor die and electrically conductive contact pads on a circuit board.

### SUMMARY OF THE INVENTION

The present invention provides an elastic circuit comprising: a substrate having an outer surface, said substrate being formed of a non-conductive elastic material; and a conductive elastomer thermally grafted directly to at least a portion of said outer surface of said substrate, said conductive elastomer having an outer surface and being formed of a non-conductive elastic material having a quantity of conductive flakes interspersed in said elastomer, and a quantity of conductive particles either interspersed in the non-conductive elastic material such that at least some of the conductive particles are present along the outer surface of the conductive elastomer, or imbedded in the outer surface of the conductive elastomer such that at least a portion of the conductive particles extends beyond the outer surface of the conductive elastomer.

In one application, the conductive elastomer is grafted to an elastic substrate to form electrically conductive circuit traces. In another application, the conductive elastomer is grafted to an elastic substrate which is used as a telephone, computer, or calculator keypad. In still another application, the conductive elastomer is grafted to an elastic substrate to form a shield against unwanted electric and magnetic fields. Additionally, the present invention provides a method for grafting a conductive elastomer to an elastic substrate, said method comprising the steps of: providing a substrate, said substrate having an outer surface, said substrate being formed of a non-conductive elastic material; applying a conductive elastomer to said outer surface of said substrate, said conductive elastomer having an outer surface and being formed of a non-conductive elastic material having a quantity of conductive flakes interspersed in said elastomer, and a quantity of conductive particles either interspersed in the non-conductive elastic material such that at least some of the conductive particles are present along the outer surface of the conductive elastomer, or applied to the outer surface of the conductive elastomer; subjecting said substrate and said conductive elastomer to a thermal process so that polymer chains in said non-conductive elastic material of said conductive elastomer are grafted to polymer chains in said non-conductive elastic material of said substrate; such that at least some of the conductive particles applied to the outer surface of the conductive elastomer become imbedded in the outer surface of the conductive elastomer and at least a portion of the conductive particles extends beyond the outer surface of the conductive elastomer after subjecting said substrate and said conductive elastomer to said thermal process.

The present invention also provides a method for grafting a conductive elastomer to a thermoset or thermoplastic substrate, said method comprising the steps of: providing a substrate, said substrate having an outer surface, said substrate being formed of a non-conductive thermoset or thermoplastic material; applying a conductive elastomer to said outer surface of said substrate, said conductive elastomer having an outer surface and being formed of a mixture of a non-conductive elastic material, a quantity of conductive flakes, a thermoplastic elastomer material, a thermoset or thermoplastic material, and a quantity of conductive particles either interspersed in the mixture such that at least some of the conductive particles are present along the outer surface of the conductive elastomer, or applied to the outer surface of the conductive elastomer; and subjecting said substrate and said conductive elastomer to a thermal process so that polymer chains in said conductive elastomer are grafted to polymer chains in said substrate; such that at least some of the conductive particles applied to the outer surface of the conductive elastomer become imbedded in the outer surface of the conductive elastomer and at least a portion of the conductive particles extends beyond the outer surface of the conductive elastomer after subjecting said substrate and said conductive elastomer to said thermal process.

In addition, the present invention provides a method for grafting a conductive elastomer to a metal substrate, said method comprising the steps of: providing a substrate, said substrate having an outer surface, said substrate being formed of a conductive noble metal material; applying a conductive elastomer to said outer surface of said substrate, said conductive elastomer having an outer surface and being formed of a mixture of a non-conductive elastic material, a quantity of conductive flakes, a thermoplastic elastomer material, a conductive thermoplastic polymer material, a conductive metal material, and a quantity of conductive particles either interspersed in the non-conductive elastic material such that at least some of the conductive particles are present along the outer surface of the conductive elastomer, or applied to the outer surface of the conductive elastomer; and subjecting said substrate and said conductive elastomer to a thermal process so that polymer chains in said conductive elastomer are grafted to polymer chains in said substrate; such that at least some of the conductive particles applied to the outer surface of the conductive elastomer become imbedded in the outer surface of the conductive elastomer and at least a portion of the conductive particles extends beyond the outer surface of the conductive elastomer after subjecting said substrate and said conductive elastomer to said thermal process.

In view of the foregoing, it is readily apparent that the primary object of the present invention is to provide an electrically conductive elastomer for grafting to an elastic substrate, a thermoplastic substrate, a thermoset substrate and a metal substrate.

The above-stated primary object, as well as other objects, features, and advantages, of the present invention will become more readily apparent from the following detailed description which is to be read in conjunction with the appended drawings.

### BRIEF DESCRIPTION OF THE DRAWINGS

In order to facilitate a fuller understanding of the present invention, reference is now made to the appended drawings. These drawings should not be construed as limiting the present invention, but are intended to be exemplary only.

Figure 1 is a perspective view of an elastic substrate having several integrated circuit components electrically interconnected with electrically conductive traces formed with an electrically conductive elastomer material in accordance with the present invention.

Figure 2 is a cross-sectional view of the elastic substrate shown in Figure 1 having the electrically conductive elastomer material grafted thereto in accordance with the present invention.

Figure 3 is an edge view of the elastic substrate shown in Figure 1 in a deformed state for purposes of demonstrating that the electrically conductive elastomer material may still perform its intended function while being deformed.

Figure 4 is a cross-sectional view of a keypad comprising an elastic cover and having an electrically conductive elastomer material grafted to the elastic cover in accordance with the present invention.

Figure 5 is a perspective view of an elastic EMI shield having an elastic substrate and an electrically conductive elastomer material grafted to a surface of the elastic substrate in accordance with the present invention.

Figure 6 is a perspective view of the underside of the elastic EMI shield shown in Figure 5.

Figure 7 is a cross-sectional view of a section of the elastic EMI shield shown in Figure 5 in one embodiment.

Figure 8 is a cross-sectional view of a section of the elastic EMI shield shown in Figure 5 in another embodiment.

Figure 9 is a cross-sectional view of a section of the elastic EMI shield shown in Figure 5 in still another embodiment.

Figure 10 is a cross-sectional view of a section of the elastic EMI shield shown in Figure 5 in a further embodiment.

Figure 11 is a perspective view of a circuit board having a plurality of electrically conductive contact pads and electrically conductive traces formed thereon with an electrically conductive elastomer material in accordance with the present invention.

Figure 12 is a perspective view of a flex film having a plurality of electrically conductive contact pads and a plurality of electrically conductive traces formed thereon with an electrically conductive elastomer material in accordance with the present invention.

Figure 13 is a cross-sectional view of a thermoset or a thermoplastic substrate having an electrically conductive elastomer material with imbedded conductive indenting particles grafted thereto in accordance with the present invention.

Figure 14 is a cross-sectional view of a thermoset or a thermoplastic substrate having an electrically conductive elastomer material with imbedded conductive piercing particles grafted thereto in accordance with the present invention.

Figure 15 is a cross-sectional view of a thermoset or a thermoplastic substrate having an electrically conductive elastomer material with conductive indenting particles grafted thereto in accordance with the present invention.

Figure 16 is a cross-sectional view of a thermoset or a thermoplastic substrate having an electrically conductive elastomer material with conductive piercing particles grafted thereto in accordance with the present invention.

Figure 17 is a perspective view of a section of a circuit board having a plurality of electrically conductive contact pads which have an electrically conductive elastomer material grafted thereto for making electrical connections with electrically conductive contact points on a semiconductor die in accordance with the present invention.

Figure 18 is an exploded cross-sectional view of a circuit board having a plurality of electrically conductive contact pads which have an electrically conductive elastomer material grafted thereto for making electrical connections with electrically conductive contact points on a semiconductor die in accordance with the present invention.

Figure 19 is a cross-sectional view of a noble metal or noble metal composite material substrate having an electrically conductive elastomer material with imbedded conductive indenting particles grafted thereto in accordance with the present invention.

Figure 20 is a cross-sectional view of a noble metal or noble metal composite material substrate having an electrically conductive elastomer material with imbedded conductive piercing particles grafted thereto in accordance with the present invention.

Figure 21 is a cross-sectional view of a noble metal or noble metal composite material substrate having an electrically conductive elastomer material with conductive indenting particles grafted thereto in accordance with the present invention.

Figure 22 is a cross-sectional view of a noble metal or noble metal composite material substrate having an electrically conductive elastomer material with conductive piercing particles grafted thereto in accordance with the present invention.

### DETAILED DESCRIPTION OF THE INVENTION

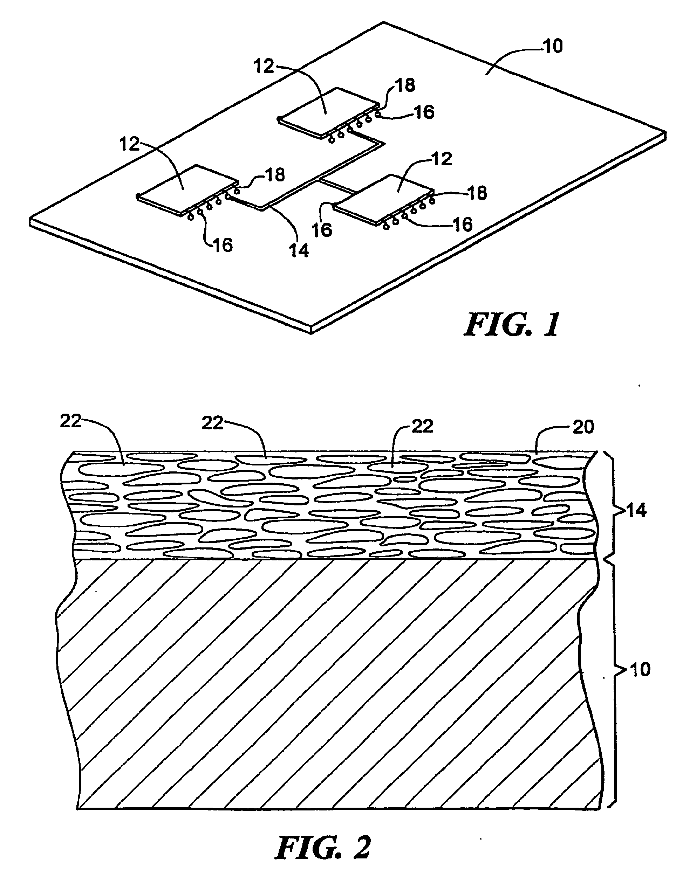

Referring to Figure 1, there is shown a perspective view of an elastic substrate 10 having several integrated circuit components 12 mounted thereon. The integrated circuit components 12 are electrically interconnected with electrically conductive traces 14 (only one shown for illustrative purposes). The electrically conductive traces 14 are formed of an electrically conductive elastomer material which is grafted directly to the elastic substrate 10.

The elastic substrate 10 may be fabricated of one of many elastic materials such as, for example, silicone rubber or flourosilicone rubber. The elastic substrate 10 has electrically conductive through-holes 16 formed therein. The integrated circuit components 12 have electrically conductive leads 18 extending therefrom. The integrated circuit components 12 are mounted to the elastic substrate 10 by mating the electrically conductive leads 18 with the electrically conductive through-holes 16 and soldering the same together by many known conventional methods. The electrically conductive elastomer material is grafted directly to the elastic substrate 10 so as to form the electrically conductive traces 14, which extend between the electrically conductive through-holes 16 thereby making electrical connections between the integrated circuit components 12. It should be noted that in an alternative embodiment, the electrically conductive elastomer material may extend between contact areas other than through-holes, such as for example surface mount pads or circuit board edge contacts.

Referring to Figure 2, there is shown a cross-sectional view of the elastic substrate 10 with the electrically conductive elastomer material 14 grafted thereto. The electrically conductive elastomer material 14 comprises a mixture of an elastic material 20 and a quantity of electrically conductive flakes 22. The elastic material 20 may be fabricated of one of many elastic materials such as, for example, silicone rubber or flourosilicone rubber. The conductive flakes 22 may be fabricated of many different types of conductive or semiconductive materials such as, for example, silver, nickel, or carbon. Alternatively, the conductive flakes 22 may be fabricated of many different types of conductive, semiconductive, or insulative materials which are coated with or have interspersed therein other conductive or semiconductive materials such as, for example, silver, nickel, or carbon. The size of the conductive flakes 22 may vary depending on the level of conductivity that is required and the size of the electrically conductive traces 14.

The electrically conductive elastomer material 14 is grafted to the elastic substrate 10 by a thermal grafting process which typically begins by providing the elastic substrate 10 in a fully cured state. The electrically conductive elastomer material 14 is deposited on the elastic substrate 10 in an uncured state by spray coating, roller coating, transfer pad printing, or any of a variety of other known methods. The elastic substrate 10 and the electrically conductive elastomer material 14 are then subjected to a thermal cycle whereby the electrically conductive elastomer material 14 is fully cured and grafted to the elastic substrate 10. During this thermal grafting process, polymer chains in the electrically conductive elastomer material 14 are grafted to polymer chains in the elastic substrate 10 so as to form a strong chemical bond. In the uncured state, the elastic material 20 and the conductive flakes 22 are typically suspended in a solvent, for example, TOLUENE^{™}, which evaporates during the thermal cycle. It should be noted that the grafting process may alternatively involve irradiation or compressive bonding to fully cure and graft the electrically conductive elastomer material 14 to the elastic substrate 10.

The conductive flakes 22 which are interspersed within the elastic material 20 of the electrically conductive elastomer material 14 provide low resistivity even when the electrically conductive elastomer material 14 is being deformed through expansion or compression since the surface area of the conductive flakes 22 is large enough for electrical contact to be made between adjacent conductive flakes 22 when such deformities occur. For instance, during lengthwise expansion of the electrically conductive elastomer material 14, the length of the electrically conductive elastomer material 14 is increased while the thickness of the electrically conductive elastomer material 14 is decreased. The decrease in thickness brings adjacent conductive flakes 22 closer together, thereby increasing the likelihood that the large surface areas of adjacent conductive flakes 22 will come into physical, and hence electrical, contact with each other. The increase in length results in lateral movement of the conductive flakes 22, thereby causing the large surface areas of adjacent conductive flakes 22 to rub or scrape against each other so that physical, and hence electrical, contact between adjacent conductive flakes 22 is maintained.

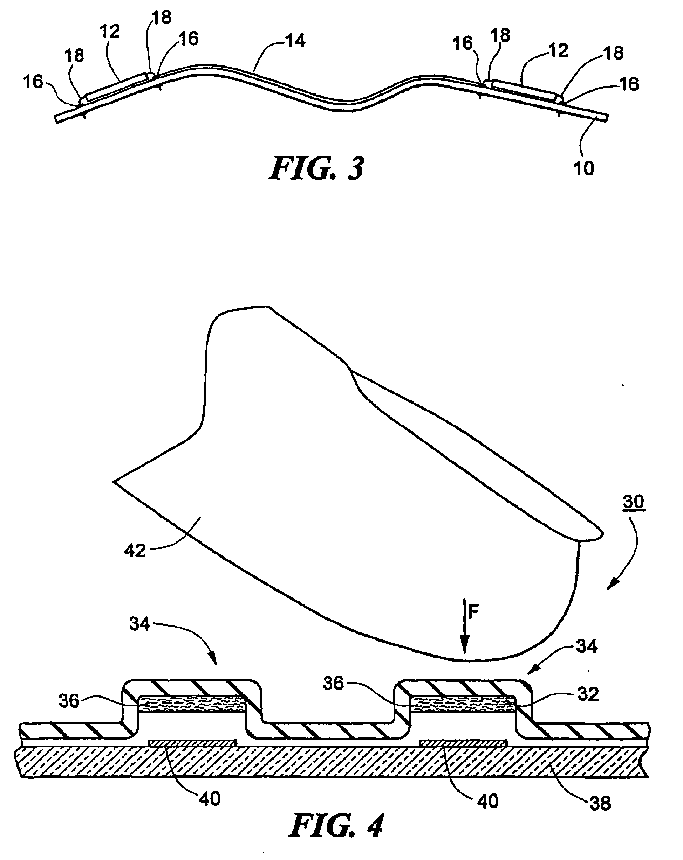

Referring to Figure 3, there is shown an edge view of the elastic substrate 10 with the integrated circuit components 12 mounted thereon and the electrically conductive elastomer material 14 grafted thereto. The elastic substrate 10 and the electrically conductive elastomer material 14 are both shown in a deformed state for purposes of demonstrating that the electrically conductive elastomer material 14 will still perform its intended function while being deformed. That is, despite the fact that the electrically conductive elastomer material 14 is deformed, the electrically conductive elastomer material 14 still maintains electrical connections between the integrated circuit components 12.

The durometer rating of the elastic material 20 in the electrically conductive elastomer material 14 typically ranges between 40 and 80 on the Shore A scale. Such a durometer rating allows the electrically conductive elastomer material 14 to be expanded or compressed to at least 33% of its at-rest shape. When such a deformation occurs, the conductive flakes 22 interspersed within the elastic material 20 of the electrically conductive elastomer material 14 interact as described above so as to maintain a low resistivity throughout the electrically conductive elastomer material 14. An electrically conductive elastomer material that has been grafted to an elastic substrate in accordance with the present invention has been shown to maintain a resistance in the range of 20-30 mohms during measurements performed while deforming the electrically conductive elastomer material within the above-described limits.

At this point it should be noted that although the elastic substrate 10 has been shown above with leaded integrated circuit components 12 mounted thereto, it also possible to utilize the present invention in an environment where discrete components or surface mount components are used. Furthermore, although only a single layered elastic substrate 10 has been shown above, it is also possible to utilize the present invention on multilayer elastic substrates or printed circuit boards.

One particular application wherein the above-described electrically conductive elastomer material would be useful is a telephone, calculator, or computer keypad wherein an electrical connection must be made by pressing a key on the keypad. Such a keypad is constructed with an elastic material such as, for example, silicone rubber or flourosilicone rubber, and an electrically conductive elastomer material is grafted onto a surface of that elastic material according to the above-described process. Thus, when a key of the keypad is pressed against a mating electrically conductive surface, such as an electrically conductive contact area on a printed circuit board, an electrical connection is made between the electrically conductive elastomer material and the electrically conductive contact.

Referring to Figure 4, there is shown a cross-sectional view of a telephone, calculator, or computer keypad 30 comprising an elastic cover 32 having keys 34 formed therein. On the underside of the cover 32, beneath each of the keys 34, an electrically conductive elastomer material 36 is grafted to the elastic cover 32.

A printed circuit board 38 is positioned beneath the cover 32, and electrically conductive traces 40 are formed on the printed circuit board 38 beneath the keys 34. Thus, when a force F is applied to one of the keys 34 of the elastic cover 32 from, for example, a human finger 42, the electrically conductive elastomer material 36 will come into electrical contact with a corresponding one of the electrically conductive traces 40.

Another particular application wherein the above-described electrically conductive elastomer material would be useful is a shield for electromagnetic interference (EMI) or other such purposes. Such a shield is constructed with an elastic material such as, for example, silicone rubber or flourosilicone rubber, and an electrically conductive elastomer material is grafted onto a surface of that elastic material according to the above-described process. The electrically conductive elastomer material provides an electrically conductive shield for preventing the propagation of unwanted electric and magnetic fields for EMI or other purposes.

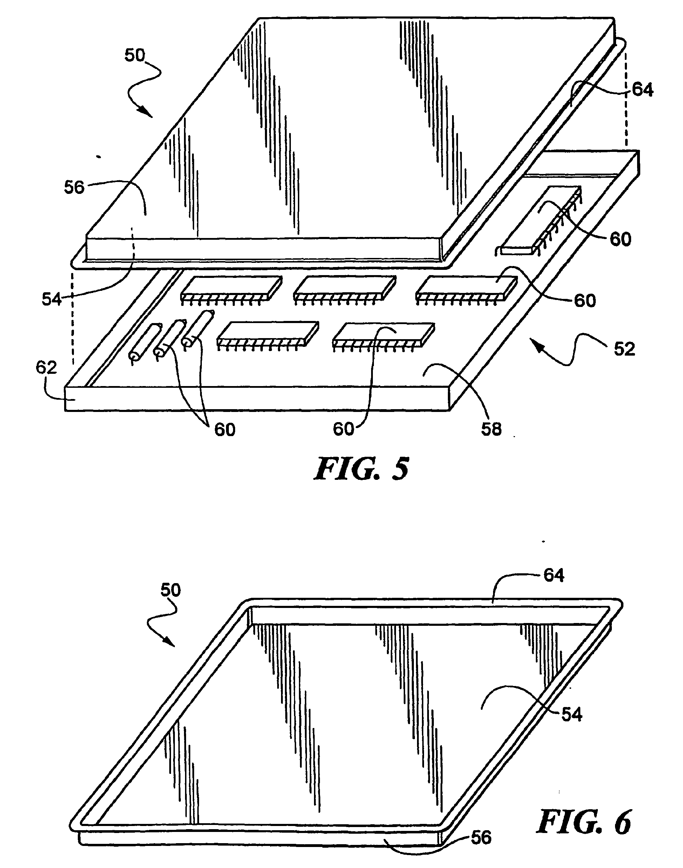

Referring to Figure 5, there is shown a perspective view of an elastic EMI shield 50 for shielding unwanted electric and magnetic fields from a mating circuit board assembly 52. The elastic EMI shield 50 is fabricated with an elastic material such as, for example, silicone rubber or flourosilicone rubber, which is shaped according to the particular application. The elastic material is then coated with an electrically conductive elastomer material. The electrically conductive elastomer material may be grafted onto either an inner 54 or an outer 56 surface of the elastic material according to the above-described process. The electrically conductive elastomer material may also be grafted onto both the inner 54 and the outer 56 surfaces.

The mating circuit board assembly 52 comprises a electronic circuit board 58 having a plurality of electronic components 60 mounted thereon. The circuit board 58 is mounted in a case 62 such as, for example, a cellular telephone case. The elastic EMI shield 50 is shaped so as to cover and enclose the electronic components 60 on the circuit board 58. The elastic EMI shield 50 may be secured to either the circuit board 58 or the case 62 by many methods including soldering, adhesives, or applied pressure, as described below.

Referring to Figure 6, there is shown a perspective view of the underside of the elastic EMI shield 50. Along the entire edge of the elastic EMI shield 50 is a lip 64. When the electrically conductive elastomer material is grafted onto the inner surface 54 of the elastic EMI shield 50, an additional electrically conductive material may be applied to the inner surface 54 in the area of the lip 64. As described in detail below, this additional electrically conductive material may take the form of electrically conductive piercing or indenting particles. These particles serve to insure that an electrical connection is made between the electrically conductive elastomer material and either the circuit board 58 or the case 62 when the elastic EMI shield 50 is mated therewith.

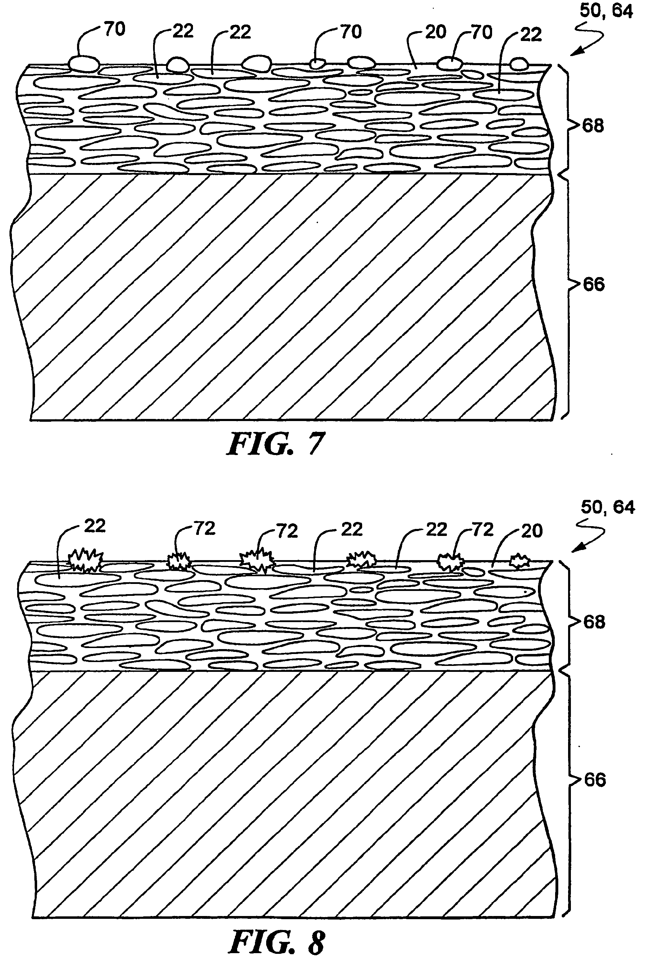

Referring to Figure 7, there is shown a cross-sectional view of the elastic EMI shield 50 in the area of the lip 64. The elastic EMI shield 50 comprises an elastic substrate 66 with an electrically conductive elastomer material 68 grafted thereto. The elastic substrate 66 may be fabricated of one of many elastic materials such as, for example, silicone rubber or flourosilicone rubber. Similar to the electrically conductive elastomer material 14 described in Figure 2, the electrically conductive elastomer material 68 comprises a mixture of an elastic material 20 and a quantity of electrically conductive flakes 22. The electrically conductive elastomer material 68 also comprises a quantity of electrically conductive indenting particles 70 that are imbedded into the surface of the electrically conductive elastomer material 68. The conductive indenting particles 70 are preferably applied to the surface of the electrically conductive elastomer material 68 prior to a thermal cycle so that the particles 70 are secured to the electrically conductive elastomer material 68 when it fully cures. The indenting nature of the conductive indenting particles 70 provides a means by which an insulating oxide which may have formed on an electrically conductive surface which is to come into contact with the lip 64 of the elastic EMI shield 50 (i.e., the circuit board 58 or the case 62) may be pushed aside so that an improved electrical connection may be formed between that electrically conductive surface and the electrically conductive elastomer material 68 of the elastic EMI shield 50. It should be noted that the conductive indenting particles 70 may push aside other contaminants such as fibers and particulates which may be present on a mating conductive surface.

The conductive indenting particles 70 may be fabricated of many different types of conductive or semiconductive materials such as, for example, silver, nickel, or carbon. Alternatively, the conductive indenting particles 70 may be fabricated of many different types of conductive, semiconductive, or insulative materials which are coated with or have interspersed therein other conductive or semiconductive materials such as, for example, silver, nickel, or carbon. The conductive indenting particles 70 typically have a 50 µm average particle size.

Referring to Figure 8, there is shown a cross-sectional view of another embodiment of the elastic EMI shield 50 in the area of the lip 64. In this particular embodiment, the electrically conductive elastomer material 68 has a quantity of electrically conductive piercing particles 72 that are imbedded into the surface of the electrically conductive elastomer material 68. The conductive piercing particles 72 are preferably applied to the surface of the electrically conductive elastomer material 68 prior to a thermal cycle so that the particles 72 are secured to the electrically conductive elastomer material 68 when it fully cures. The piercing nature of the conductive piercing particles 72 provides a means by which an insulating oxide which may have formed on an electrically conductive surface which is to come into contact with the lip 64 of the elastic EMI shield 50 (i.e., the circuit board 58 or the case 62) may be pierced so that an improved electrical connection may be formed between that electrically conductive surface and the electrically conductive elastomer material 68 of the elastic EMI shield 50. It should be noted that the conductive piercing particles 72 may pierce through other contaminants such as fibers and particulates which may be present on a mating conductive surface.

Similar to the conductive indenting particles 70, the conductive piercing particles 72 may be fabricated of many different types of conductive or semiconductive materials such as, for example, silver, nickel, or carbon. Alternatively, the conductive piercing particles 72 may be fabricated of many different types of conductive, semiconductive, or insulative materials which are coated with or have interspersed therein other conductive or semiconductive materials such as, for example, silver, nickel, or carbon. The conductive piercing particles 72 typically have a 40 µm average particle size.

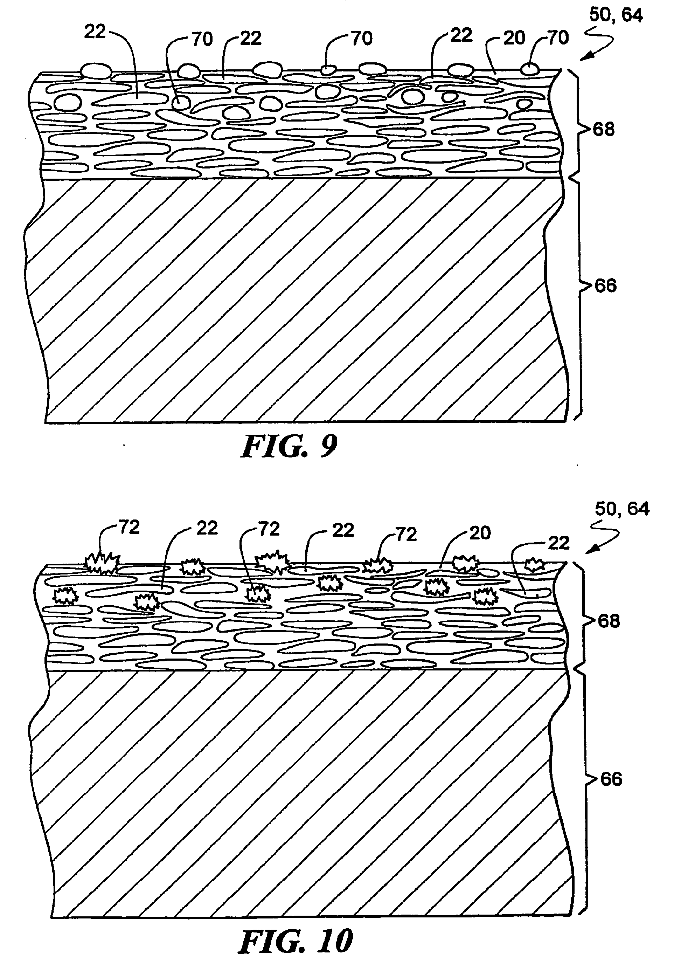

Referring to Figure 9, there is shown a cross-sectional view of another embodiment of the elastic EMI shield 50 in the area of the lip 64. In this particular embodiment, the electrically conductive elastomer material 68 comprises a mixture of an elastic material 20, a quantity of electrically conductive flakes 22, and a quantity of the electrically conductive indenting particles 70. That is, the conductive indenting particles 70 are deposited on the elastic substrate 66 along with the elastic material 20 and the conductive flakes 22. The distribution of the conductive indenting particles 70 in the electrically conductive elastomer material 68 is shown to be near the surface of the electrically conductive elastomer material 68 since the conductive indenting particles 70 are more likely than the conductive flakes 22 to bounce off the elastic substrate 66 during the application of the electrically conductive elastomer material 68. That is, when the electrically conductive elastomer material 68 is applied to the elastic substrate 66 by spray coating, the conductive indenting particles 70 are more likely to bounce off the elastic substrate 66 than the conductive flakes 22. Of course, this location for the conductive indenting particles 70 is preferable based on their functionality (e.g., to push aside oxide on a mating conductive surface). The amount of the conductive indenting particles 70 in the electrically conductive elastomer material 68 need typically only be 5% nominal by weight in order to insure their proper functionality.

Referring to Figure 10, there is shown a cross-sectional view of another embodiment of the elastic EMI shield 50 in the area of the lip 64. In this particular embodiment, the electrically conductive elastomer material 68 comprises a mixture of an elastic material 20, a quantity of electrically conductive flakes 22, and a quantity of the electrically conductive piercing particles 72. That is, the conductive piercing particles 72 are deposited on the elastic substrate 66 along with the elastic material 20 and the conductive flakes 22. The distribution of the conductive piercing particles 72 in the electrically conductive elastomer material 68 is shown to be near the surface of the electrically conductive elastomer material 68 since the conductive piercing particles 72 are more likely than the conductive flakes 22 to bounce off the elastic substrate 66 during the application of the electrically conductive elastomer material 68. That is, when the electrically conductive elastomer material 68 is applied to the elastic substrate 66 by spray coating, the conductive piercing particles 72 are more likely to bounce off the elastic substrate 66 than the conductive flakes 22. Of course, this location for the conductive piercing particles 72 is preferable based on their functionality (e.g., to pierce through oxide on a mating conductive surface). The amount of the conductive piercing particles 72 in the electrically conductive elastomer material 68 need typically only be 5% nominal by weight in order to insure their proper functionality.

At this point it should be noted that any of the above-described electrically conductive elastomer materials, including those with electrically conductive piercing and indenting particles, may be utilized for any number of applications wherein an electrically conductive surface, trace, coating, or other electrically conductive element having elastic properties is required. For example, an electrically conductive elastomer material may be grafted to an elastic substrate for purposes of forming a conductive plane for shielding or grounding purposes or the like. The density and grouping of the conductive flakes in the above-described electrically conductive elastomer materials are such that extremely effective shielding or grounding layers may be provided.

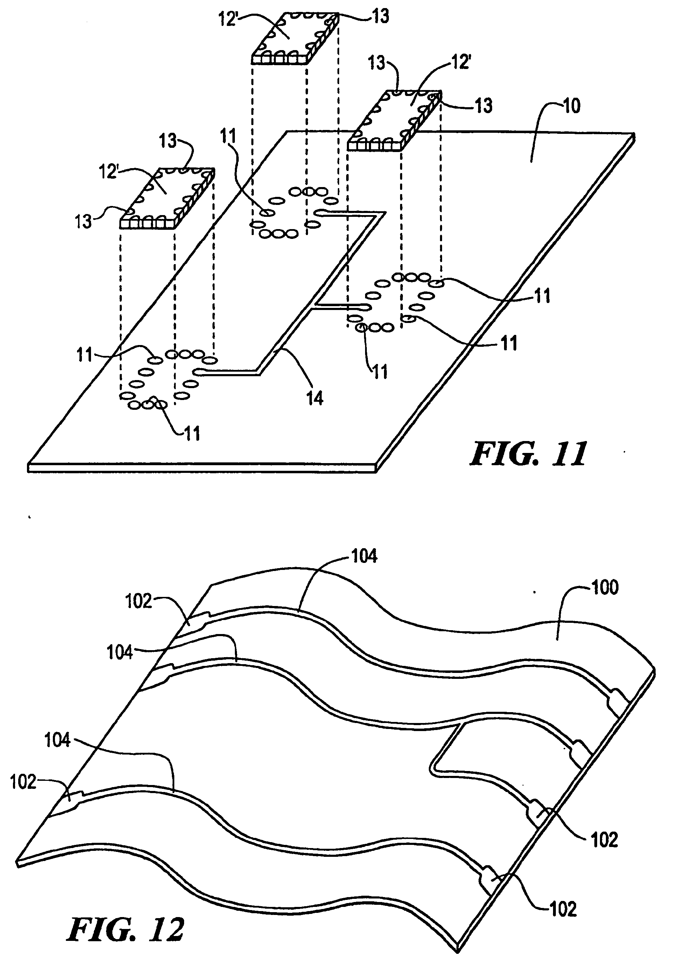

Referring now to Figure 11, there is shown a perspective view of a circuit board 10 having a plurality of electrically conductive contact pads 11 for making electrical connections with terminals 13 on several corresponding surface mount integrated circuit components 12'. The electrically conductive contact pads 11 are electrically interconnected with electrically conductive traces 14 (only one shown for illustrative purposes). The electrically conductive contact pads 11 and the electrically conductive traces 14 are formed with an electrically conductive elastomer material which is grafted directly to the circuit board 10.

The circuit board 10 may be fabricated of one of many different types of thermoset materials such as, for example, FR4™. The electrically conductive elastomer material is grafted directly to the thermoset material of the circuit board 10 so as to form the electrically conductive contact pads 11 and the electrically conductive traces 14. Electrical connections between the electrically conductive contact pads 11 and the terminals 13 on the surface mount integrated circuit components 12' may be made by simply by forcing the terminals 13 on the surface mount integrated circuit components 12' against the electrically conductive contact pads 11. The electrically conductive traces 14 provide electrical interconnections between the electrically conductive contact pads 11, and hence between the surface mount integrated circuit components 12'.

The electrically conductive elastomer material comprises a mixture of an elastic material, a quantity of electrically conductive flakes, a thermoplastic elastomer material, and a thermoset material. The elastic material may be any one of a variety of elastic materials such as, for example, silicone rubber or flourosilicone rubber. The conductive flakes may be fabricated of many different types of conductive or semiconductive materials such as, for example, silver, nickel, or carbon. Alternatively, the conductive flakes may be fabricated of many different types of conductive, semiconductive, or insulative materials which are coated with or have interspersed therein other conductive or semiconductive materials such as, for example, silver, nickel, or carbon. The size of the conductive flakes may vary depending on the level of conductivity that is required and the size of the electrically conductive contact pads 11 and the electrically conductive traces 14.

The thermoplastic elastomer material may be any one of a variety of thermoplastic elastomers such as, for example, VITON^{™}. The thermoplastic elastomer material provides a bridging function between the elastic material and the thermoset material in the electrically conductive elastomer material. That is, as described in more detail below, polymer chains in the thermoplastic elastomer material are grafted to polymer chains in the elastic material and the thermoset material when electrically conductive elastomer material is grafted to the circuit board 10.

Assuming that the circuit board 10 is fabricated of the thermoset material FR4^{™}, which comprises epoxy and glass fibers, the thermoset material is also FR4^{™}. This relationship between the type of thermoset material in the electrically conductive elastomer material and the material type of the circuit board 10 insures that a strong chemical bond will form between the electrically conductive elastomer material and the circuit board 10 when the electrically conductive elastomer material is grafted to the circuit board 10. That is, as described in more detail below, polymer chains in the thermoset material of the electrically conductive elastomer material are grafted to polymer chains in the thermoset material of the circuit board 10 when the electrically conductive elastomer material is grafted to the circuit board 10.

The electrically conductive elastomer material is grafted to the circuit board 10 by a thermal grafting process which typically begins by providing the circuit board 10 in a fully cured state. The electrically conductive elastomer material is deposited on the circuit board 10 in an uncured state by spray coating, roller coating, transfer pad printing, or any of a variety of other known methods. The circuit board 10 and the electrically conductive elastomer material are then subjected to a thermal cycle whereby the electrically conductive elastomer material is fully cured and grafted to the circuit board 10. During this thermal grafting process, polymer chains in the electrically conductive elastomer material are grafted to polymer chains in the circuit board 10 so as to form a strong chemical bond between the electrically conductive elastomer material and the circuit board 10. In the uncured state, the elastic material, the conductive flakes, the thermoplastic elastomer material, and the thermoset material are typically suspended in a solvent, for example, TOLUENE^{™}, which evaporates during the thermal cycle. It should be noted that the grafting process may alternatively involve irradiation or compressive bonding to fully cure and graft the electrically conductive elastomer material to the circuit board 10.

The conductive flakes in the electrically conductive elastomer material provide low resistivity even when the electrically conductive elastomer material is being deformed through expansion or compression since the surface area of the conductive flakes is large enough for electrical contact to be made between adjacent conductive flakes when such deformities occur. For instance, during lengthwise expansion of the electrically conductive elastomer material, the length of the electrically conductive elastomer material is increased while the thickness of the electrically conductive elastomer material is decreased. The decrease in thickness brings adjacent conductive flakes closer together, thereby increasing the likelihood that the large surface areas of adjacent conductive flakes will come into physical, and hence electrical, contact with each other. The increase in length results in lateral movement of the conductive flakes, thereby causing the large surface areas of adjacent conductive flakes to rub or scrape against each other so that physical, and hence electrical, contact between adjacent conductive flakes is maintained.

The durometer rating of the electrically conductive elastomer material typically ranges between 40 and 80 on the Shore A scale. Such a durometer rating allows the electrically conductive elastomer material to be expanded or compressed to at least 33% of its at-rest shape. When such a deformation occurs, the conductive flakes interspersed in the electrically conductive elastomer material interact as described above so as to maintain a low resistivity throughout the electrically conductive elastomer material. An electrically conductive elastomer material that has been grafted to a circuit board in accordance with the present invention has been shown to maintain a resistance in the range of 20-30 mohms during measurements performed while deforming the electrically conductive elastomer material within the above-described limits.

At this point it should be noted that although the circuit board 10 has been shown above with corresponding leadless surface mount integrated circuit components 12', it is also possible to utilize the present invention in an environment where discrete or otherwise leaded components are used. Furthermore, although only a single layered circuit board 10 has been shown above, it is also possible to utilize the present invention on multilayer circuit boards.

In an alternative embodiment, the above-described electrically conductive elastomer material could be used in conjunction with a flex film circuit. Referring to Figure 12, there is shown a perspective view of a flex film 100 having a plurality of electrically conductive contact pads 102 and a plurality of electrically conductive traces 104 formed thereon. The electrically conductive traces 104 provide electrical interconnections between the electrically conductive contact pads 102. The electrically conductive contact pads 102 and the electrically conductive traces 104 are formed with an electrically conductive elastomer material which is grafted directly to the flex film 100.

The flex film 100 may be fabricated of one of many different types of thermoplastic materials such as, for example, KAPTON^{™}. The electrically conductive elastomer material is grafted directly to the thermoplastic material of the flex film 100 so as to form the electrically conductive contact pads 102 and the electrically conductive traces 104.

The electrically conductive elastomer material comprises a mixture of an elastic material, a quantity of electrically conductive flakes, a thermoplastic elastomer material, and a thermoplastic material. The elastic material may be any one of a variety of elastic materials such as, for example, silicone rubber or fluorosilicone rubber. The conductive flakes may be fabricated of many different types of conductive or semiconductive materials such as, for example, silver, nickel, or carbon. Alternatively, the conductive flakes may be fabricated of many different types of conductive, semiconductive, or insulative materials which are coated with or have interspersed therein other conductive or semiconductive materials such as, for example, silver, nickel, or carbon. The size of the conductive flakes may vary depending on the level of conductivity that is required and the size of the electrically conductive contact pads 102 and the electrically conductive traces 104.

The thermoplastic elastomer material may be any one of a variety of thermoplastic elastomers such as, for example, VITON^{™}. The thermoplastic elastomer material provides a bridging function between the elastic material and the thermoplastic material in the electrically conductive elastomer material. That is, as described in more detail below, polymer chains in the thermoplastic elastomer material are grafted to polymer chains in the elastic material and the thermoplastic material when electrically conductive elastomer material is grafted to the flex film 100.

Assuming that the flex film 100 is fabricated of the thermoplastic material KAPTON^{™}, which comprises resin fibers, the thermoplastic material in the electrically conductive elastomer material is also KAPTON^{™}. This relationship between the type of thermoplastic material in the electrically conductive elastomer material and the material type of the flex film 100 insures that a strong chemical bond will form between the electrically conductive elastomer material and the flex film 100 when the electrically conductive elastomer material is grafted to the flex film 100. That is, as described in more detail below, polymer chains in the thermoplastic material of the electrically conductive elastomer material are grafted to polymer chains in the thermoplastic material of the flex film 100 when the electrically conductive elastomer material is grafted to the flex film 100.

The electrically conductive elastomer material is grafted to the flex film 100 by a thermal grafting process which typically begins by providing the flex film 100 in a fully cured state. The electrically conductive elastomer material is deposited on the flex film 100 in an uncured state by spray coating, roller coating, transfer pad printing, or any of a variety of other known methods. The flex film 100 and the electrically conductive elastomer material are then subjected to a thermal cycle whereby the electrically conductive elastomer material is fully cured and grafted to the flex film 100. During this thermal grafting process, polymer chains in the electrically conductive elastomer material are grafted to polymer chains in the flex film 100 so as to form a strong chemical bond between the electrically conductive elastomer material and the flex film 100. In the uncured state, the elastic material, the conductive flakes, the thermoplastic elastomer material, and the thermoplastic material in the electrically conductive elastomer material are typically suspended in a solvent, for example, TOLUENE^{™}, which evaporates during the thermal cycle. It should be noted that the grafting process may alternatively involve irradiation or compressive bonding to fully cure and graft the electrically conductive elastomer material to the flex film 100.

As described above, the conductive flakes in the electrically conductive elastomer material provide low resistivity even when the electrically conductive elastomer material is being deformed through expansion or compression since the surface area of the conductive flakes is large enough for electrical contact to be made between adjacent conductive flakes when such deformities occur. For instance, during lengthwise expansion of the electrically conductive elastomer material, the length of the electrically conductive elastomer material is increased while the thickness of the electrically conductive elastomer material is decreased. The decrease in thickness brings adjacent conductive flakes closer together, thereby increasing the likelihood that the large surface areas of adjacent conductive flakes will come into physical, and hence electrical, contact with each other. The increase in length results in lateral movement of the conductive flakes, thereby causing the large surface areas of adjacent conductive flakes to rub or scrape against each other so that physical, and hence electrical, contact between adjacent conductive flakes is maintained.

The durometer rating of the electrically conductive elastomer material typically ranges between 40 and 80 on the Shore A scale. Such a durometer rating allows the electrically conductive elastomer material to be expanded or compressed to at least 33% of its at-rest shape. When such a deformation occurs, the conductive flakes interspersed in the electrically conductive elastomer material interact as described above so as to maintain a low resistivity throughout the electrically conductive elastomer material. An electrically conductive elastomer material that has been grafted to a circuit board in accordance with the present invention has been shown to maintain a resistance in the range of 20-30 mohms during measurements performed while deforming the electrically conductive elastomer material within the above-described limits.

Electrical connections may be made with the electrically conductive contact pads 102 and/or the electrically conductive traces 104 by simply by forcing an electrically conductive surface such as, for example, a test probe, against the electrically conductive contact pads 102 and/or the electrically conductive traces 104. The electrically conductive elastomer material will deform under pressure applied by such an electrically conductive surface, and will return to its original shape when pressure is removed.

At this point it should be noted that for both of the electrically conductive elastomer materials described above, it is possible to add further materials to the electrically conductive elastomer material mixture which allow more intimate electrical connections to be made between the electrically conductive elastomer material and any mating electrically conductive surface.

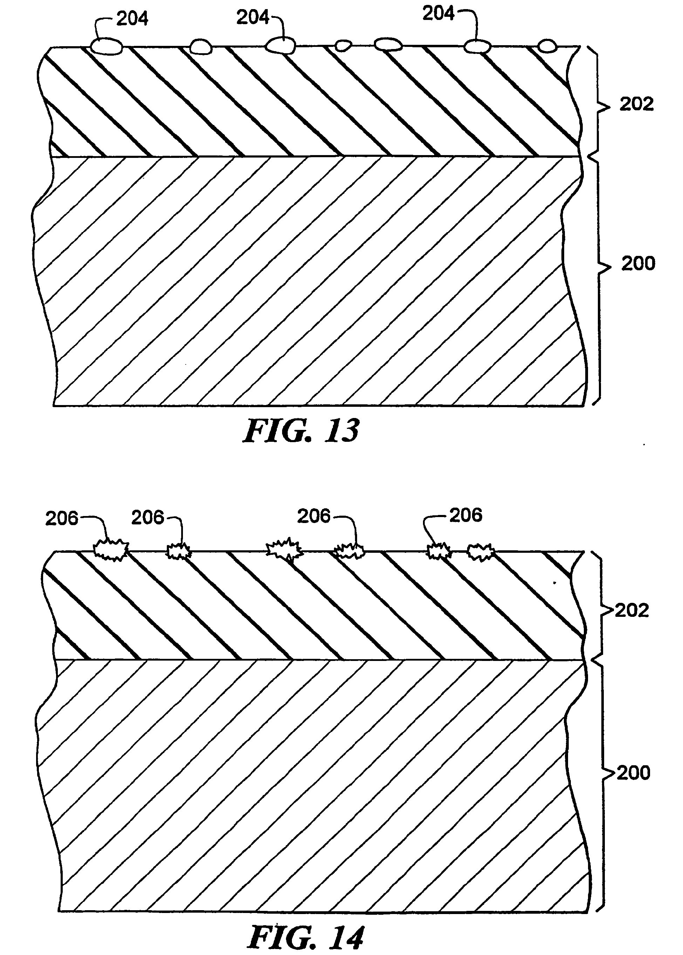

Referring to Figure 13, there is shown a cross-sectional view of either a thermoset or a thermoplastic substrate 200 having an electrically conductive elastomer material 202 grafted thereto. If the substrate 200 is a thermoset substrate, the electrically conductive elastomer material 202 comprises a mixture of an elastic material, a quantity of electrically conductive flakes, a thermoplastic elastomer material, and a thermoset material. If the substrate 200 is a thermoplastic substrate, the electrically conductive elastomer material 202 comprises a mixture of an elastic material, a quantity of electrically conductive flakes, a thermoplastic elastomer material, and a thermoplastic material.

Given that the substrate 200 is either a thermoset or a thermoplastic substrate, the electrically conductive elastomer material 202 may further comprise a quantity of electrically conductive indenting particles 204 that are imbedded into the surface of the electrically conductive elastomer material 202. The conductive indenting particles 204 are preferably applied to the surface of the electrically conductive elastomer material 202 prior to a thermal cycle so that the particles 204 are secured to the electrically conductive elastomer material 202 when it fully cures. The indenting nature of the conductive indenting particles 204 provides a means by which an insulating oxide which may have formed on an electrically conductive surface which is to come into contact with the electrically conductive elastomer material 202 may be pushed aside so that an improved electrical connection may be formed between that electrically conductive surface and the electrically conductive elastomer material 202. It should be noted that the conductive indenting particles 204 may push aside other contaminants such as fibers and particulates which may be present on a mating conductive surface.

The conductive indenting particles 204 may be fabricated of many different types of conductive or semiconductive materials such as, for example, silver, nickel, or carbon. Alternatively, the conductive indenting particles 204 may be fabricated of many different types of conductive, semiconductive, or insulative materials which are coated with or have interspersed therein other conductive or semiconductive materials such as, for example, silver, nickel, or carbon. The conductive indenting particles 204 typically have a 50 µm average particle size.

Referring to Figure 14, there is shown a cross-sectional view of either the thermoset or the thermoplastic substrate 200 having the electrically conductive elastomer material 202 grafted thereto. Given that the substrate 200 is either a thermoset or a thermoplastic substrate, the electrically conductive elastomer material 202 may further comprise a quantity of electrically conductive piercing particles 206 that are imbedded into the surface of the electrically conductive elastomer material 202. The conductive piercing particles 206 are preferably applied to the surface of the electrically conductive elastomer material 202 prior to a thermal cycle so that the particles 206 are secured to the electrically conductive elastomer material 202 when it fully cures. The piercing nature of the conductive piercing particles 206 provides a means by which an insulating oxide which may have formed on an electrically conductive surface which is to come into contact with the electrically conductive elastomer material 202 may be pierced so that an improved electrical connection may be formed between that electrically conductive surface and the electrically conductive elastomer material 202. It should be noted that the conductive piercing particles 206 may pierce other contaminants such as fibers and particulates which may be present on a mating conductive surface.

The conductive piercing particles 206 may be fabricated of many different types of conductive or semiconductive materials such as, for example, silver, nickel, or carbon. Alternatively, the conductive piercing particles 206 may be fabricated of many different types of conductive, semiconductive, or insulative materials which are coated with or have interspersed therein other conductive or semiconductive materials such as, for example, silver, nickel, or carbon. The conductive piercing particles 206 typically have a 40 µm average particle size.

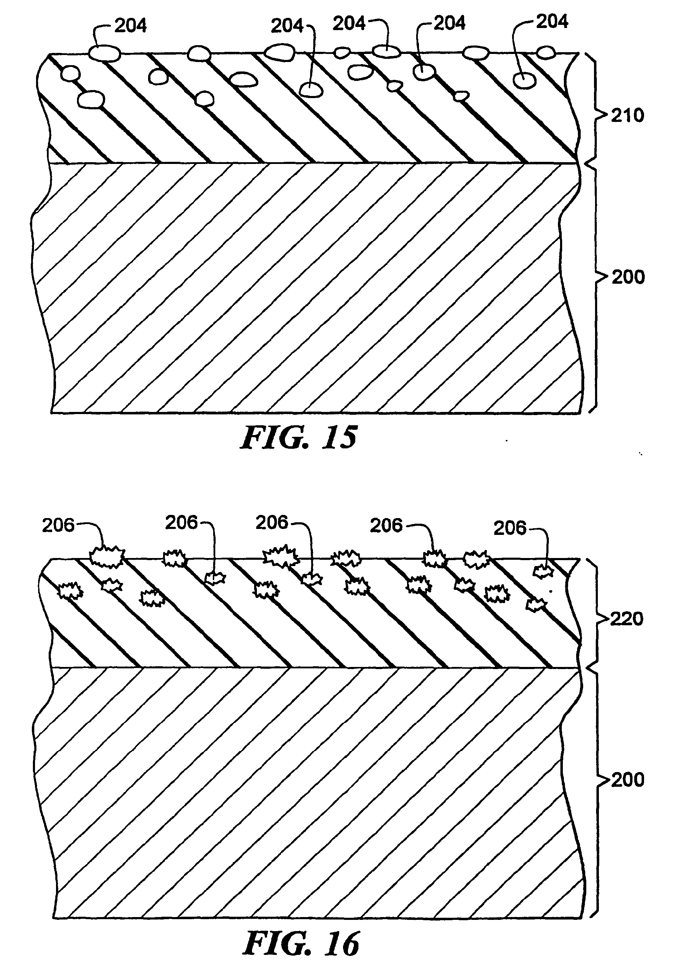

Referring to Figure 15, there is shown a cross-sectional view of either the thermoset or the thermoplastic substrate 200 having an electrically conductive elastomer material 210 grafted thereto. If the substrate 200 is a thermoset substrate, the electrically conductive elastomer material 210 comprises a mixture of an elastic material, a quantity of electrically conductive flakes, a thermoplastic elastomer material, a thermoset material, and a quantity of the electrically conductive indenting particles 204 (only the indenting particles are shown for purposes of figure clarity). That is, the conductive indenting particles 204 are deposited on the substrate 200 along with the rest of the materials in the electrically conductive elastomer material 210. If the substrate 200 is a thermoplastic substrate, the electrically conductive elastomer material 210 comprises a mixture of an elastic material, a quantity of electrically conductive flakes, a thermoplastic elastomer material, a thermoplastic material, and a quantity of the electrically conductive indenting particles 204 (only the indenting particles are shown for purposes of figure clarity). That is, the conductive indenting particles 204 are deposited on the substrate 200 along with the rest of the materials in the electrically conductive elastomer material 210.

The distribution of the conductive indenting particles 204 in the electrically conductive elastomer material 210 is shown to be near the surface of the electrically conductive elastomer material 210 since the conductive indenting particles 204 are likely to bounce off the substrate 200 during the application of the electrically conductive elastomer material 210. That is, when the electrically conductive elastomer material 210 is applied to the substrate 200 by spray coating, the conductive indenting particles 204 are likely to bounce off the substrate 200. Of course, this location for the conductive indenting particles 204 is preferable based on their functionality (e.g., to push aside oxide on a mating conductive surface). The amount of the conductive indenting particles 204 in the electrically conductive elastomer material 210 need typically only be 5% nominal by weight in order to insure their proper functionality.

Referring to Figure 16, there is shown a cross-sectional view of either the thermoset or the thermoplastic substrate 200 having an electrically conductive elastomer material 220 grafted thereto. If the substrate 200 is a thermoset substrate, the electrically conductive elastomer material 220 comprises a mixture of an elastic material, a quantity of electrically conductive flakes, a thermoplastic elastomer material, a thermoset material, and a quantity of the electrically conductive piercing particles 206 (only the piercing particles are shown for purposes of figure clarity). That is, the conductive piercing particles 206 are deposited on the substrate 200 along with the rest of the materials in the electrically conductive elastomer material 220. If the substrate 200 is a thermoplastic substrate, the electrically conductive elastomer material 220 comprises a mixture of an elastic material, a quantity of electrically conductive flakes, a thermoplastic elastomer material, a thermoplastic material, and a quantity of the electrically conductive piercing particles 206 (only the piercing particles are shown for purposes of figure clarity). That is, the conductive piercing particles 206 are deposited on the substrate 200 along with the rest of the materials in the electrically conductive elastomer material 220.

The distribution of the conductive piercing particles 206 in the electrically conductive elastomer material 220 is shown to be near the surface of the electrically conductive elastomer material 220 since the conductive piercing particles 206 are likely to bounce off the substrate 200 during the application of the electrically conductive elastomer material 220. That is, when the electrically conductive elastomer material 220 is applied to the substrate 200 by spray coating, the conductive piercing particles 206 are likely to bounce off the substrate 200. Of course, this location for the conductive piercing particles 206 is preferable based on their functionality (e.g., to pierce oxide on a mating conductive surface). The amount of the conductive piercing particles 206 in the electrically conductive elastomer material 220 need typically only be 5% nominal by weight in order to insure their proper functionality.

At this point it should be noted that any of the above-described electrically conductive elastomer materials, including those with electrically conductive piercing and indenting particles, may be utilized for any number of applications wherein an electrically conductive surface, trace, coating, or other electrically conductive element having elastic properties is required. For example, an electrically conductive elastomer material may be grafted to a thermoset or a thermoplastic substrate for purposes of forming a conductive plane for shielding or grounding purposes or the like. The density and grouping of the conductive flakes in the above-described electrically conductive elastomer materials are such that extremely effective shielding or grounding layers may be provided.

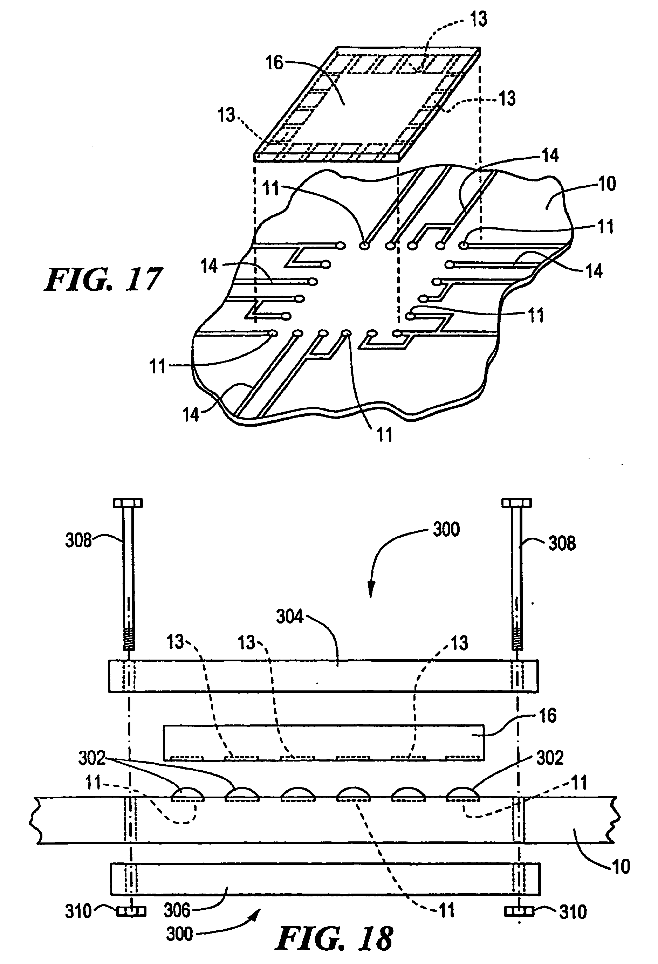

Referring to Figure 17, there is shown a perspective view of a section of a circuit board 10 having a plurality of electrically conductive contact pads 11 for making electrical connections with electrically conductive contact points 13 on a semiconductor die 16. The electrically conductive contact pads 11 have electrically conductive traces 14 extending therefrom for making electrical connections with other devices (not shown) on the circuit board 10. An electrically conductive elastomer material is grafted directly onto the surface of the electrically conductive contact pads 11 to facilitate making the electrical connections between the electrically conductive contact pads 11 on the circuit board 10 and the electrically conductive contact points 13 on the semiconductor die 16.

The circuit board 10 may be fabricated of one of many different types of material that is typically used for such purposes such as, for example, FR4^{™}. The electrically conductive contact pads 11 and the electrically conductive traces 14 are fabricated of a noble metal material or noble metal composite material such as, for example, a gold plated copper alloy. The electrically conductive contact pads 11 and the electrically conductive traces 14 may be formed on the circuit board 10 by any of the commonly known methods such as, for example, direct chemical deposition and photoresistive etching.

The electrically conductive contact points 13 are located on the underside of the semiconductor die 16 and may be formed of any type of electrically conductive material. Such electrically conductive contact points 13 are typically formed of gold.

The electrically conductive elastomer material is grafted directly to the noble metal material or noble metal composite material of the electrically conductive contact pads 11. As described in more detail below, the electrically conductive elastomer material facilitates making the electrical connections between the electrically conductive contact pads 11 on the circuit board 10 and the electrically conductive contact points 13 on the semiconductor die 16 by allowing the electrically conductive contact points 13 on the semiconductor die 16 to press against an electrically conductive deformable material so that each of the electrically conductive contact points 13 on the semiconductor die 16 will be in intimate contact with a corresponding one of the electrically conductive contact pads 11 on the circuit board 10. For example, referring to Figure 18, there is shown an exploded cross-sectional view of the circuit board 10, the semiconductor die 16, and some associated mounting hardware 300. The circuit board 10 has the electrically conductive contact pads 11 formed thereon (the electrically conductive traces 14 are not shown for purposes of figure clarity), and each of the electrically conductive contact pads 11 has an electrically conductive elastomer material 302 grafted directly thereto. The semiconductor die 16 has the electrically conductive contact points 13 formed on the underside thereof. The mounting hardware 300 comprises a heat sink 304, a back-up plate 306, a pair of mounting bolts 308, and a corresponding pair of mounting nuts 310. It should be noted that the mounting hardware 300 is shown for illustrative purposes only and that numerous other mounting schemes may instead be utilized.

When the mounting nuts 310 are tightened on the mounting bolts 308, the heat sink 304 forces the semiconductor die 16 towards the circuit board 10. Thus, the electrically conductive contact points 13 on the semiconductor die 16 are forced against the electrically conductive elastomer material 302 grafted to the electrically conductive contact pads 11 on the circuit board 10. The electrically conductive elastomer material 302 that is grafted to each electrically conductive contact pad 11 is resilient so that the electrically conductive elastomer material 302 readily adapts to the shape of and the pressure applied by a corresponding electrically conductive contact point 13 on the semiconductor die 16, thereby insuring intimate contact between each of the electrically conductive contact points 13 on the semiconductor die 16 and the electrically conductive elastomer material 302 that is grafted to a corresponding electrically conductive contact pad 11 on the circuit board 10. The electrically conductive elastomer material 302 is resilient in that it will deform under pressure applied by an electrically conductive contact point 13 on the semiconductor die 16, and will return to its original shape when pressure is removed.

The electrically conductive elastomer material 302 comprises a mixture of an elastic material, a quantity of electrically conductive flakes, a thermoplastic elastomer material, a conductive thermoplastic polymer material, and a noble metal or noble metal composite material. The elastic material may be any one of a variety of elastic materials such as, for example, silicone rubber or fluorosilicone rubber. The conductive flakes may be fabricated of many different types of conductive or semiconductive materials such as, for example, silver, nickel, or carbon. Alternatively, the conductive flakes may be fabricated of many different types of conductive, semiconductive, or insulative materials which are coated with or have interspersed therein other conductive or semiconductive materials such as, for example, silver, nickel, or carbon. The size of the conductive flakes may vary depending on the level of conductivity that is required and the size of the electrically conductive contact pads 11.

The thermoplastic elastomer material may be any one of a variety of thermoplastic elastomers such as, for example, VITON^{™}. The thermoplastic elastomer material provides a bridging function between the elastic material and the conductive thermoplastic polymer material. That is, as described in more detail below, polymer chains in the thermoplastic elastomer material are grafted to polymer chains in the elastic material and the conductive thermoplastic polymer material when electrically conductive elastomer material 302 is grafted to the electrically conductive contact pads 11.

The conductive thermoplastic polymer material is a conductive thermoplastic polymer chain comprising a thermoplastic material chain core with a conductive material at the ends of at least some, if not all, of the branches which extend off of the thermoplastic material chain core. Thus, the thermoplastic material chain core is not conductive, but the outer regions of the chain defined by the ends of the branches are. The thermoplastic material chain core provides cohesive bonds for the conductive material at the ends of the branches which extend off of the thermoplastic material chain core.

The conductive thermoplastic polymer material provides a bridging function between the thermoplastic elastomer material and the noble metal or noble metal composite material. That is, as described in more detail below, polymer chains in the conductive thermoplastic polymer material are grafted to polymer chains in the thermoplastic elastomer material and the noble metal or noble metal composite material when electrically conductive elastomer material 302 is grafted to the electrically conductive contact pads 11.

The thermoplastic material which forms the chain core may be formed from any one of a variety of thermoplastic materials such as, for example, ULTEM^{™}. The conductive material at the ends of the branches which extend off of the thermoplastic material chain core is a noble metal such as, for example, silver. It should be noted that the conductive material is in an ionic state.

If the electrically conductive contact pads 11 are fabricated of a gold plated copper alloy, the noble metal or noble metal composite material in the electrically conductive elastomer material does not also have to be a gold plated copper alloy. That is, the noble metal or noble metal composite material in the electrically conductive elastomer material 302 may be any one of a variety of noble metal or noble metal composite materials such as, for example, silver coated carbon fibers. It is sufficient that the electrically conductive contact pads 11 and the noble metal or noble metal composite material in the electrically conductive elastomer material 302 are both noble metal or noble metal composite materials to insure that a strong chemical bond will form between the electrically conductive elastomer material 302 and the electrically conductive contact pads 11 when the electrically conductive elastomer material 302 is grafted to the electrically conductive contact pads 11. That is, as described in more detail below, polymer chains in the noble metal or noble metal composite material of the electrically conductive elastomer material 302 are grafted to polymer chains in the noble metal or noble metal composite material of the electrically conductive contact pads 11 when the electrically conductive elastomer material 302 is grafted to the electrically conductive contact pads 11.

The electrically conductive elastomer material 302 is grafted to the electrically conductive contact pads 11 by a thermal grafting process which typically begins by providing the noble metal or noble metal composite material of the electrically conductive contact pads 11 in a fully cured state. The electrically conductive elastomer material 302 is deposited on the electrically conductive contact pads 11 in an uncured state by spray coating, roller coating, transfer pad printing, or any of a variety of other known methods. The electrically conductive contact pads 11 and the electrically conductive elastomer material 302 are then subjected to a thermal cycle whereby the electrically conductive elastomer material 302 is fully cured and grafted to the electrically conductive contact pads 11. During this thermal grafting process, polymer chains in the electrically conductive elastomer material 302 are grafted to polymer chains in the noble metal or noble metal composite material of the electrically conductive contact pads 11 so as to form a strong chemical bond between the electrically conductive elastomer material 302 and the electrically conductive contact pads 11. In the uncured state, the elastic material, the conductive flakes, the thermoplastic elastomer material, the conductive thermoplastic polymer material, and the noble metal or noble metal composite material are typically suspended in a solvent, for example, TOLUENE^{™}, which evaporates during the thermal cycle. It should be noted that the grafting process may alternatively involve irradiation or compressive bonding to fully cure and graft the electrically conductive elastomer material 302 to the electrically conductive contact pads 11.

The conductive flakes in the electrically conductive elastomer material 302 provide low resistivity even when the electrically conductive elastomer material 302 is being deformed through expansion or compression since the surface area of the conductive flakes is large enough for electrical contact to be made between adjacent conductive flakes when such deformities occur. For instance, during lengthwise expansion of the electrically conductive elastomer material 302, the length of the electrically conductive elastomer material 302 is increased while the thickness of the electrically conductive elastomer material 302 is decreased. The decrease in thickness brings adjacent conductive flakes closer together, thereby increasing the likelihood that the large surface areas of adjacent conductive flakes will come into physical, and hence electrical, contact with each other. The increase in length results in lateral movement of the conductive flakes, thereby causing the large surface areas of adjacent conductive flakes to rub or scrape against each other so that physical, and hence electrical, contact between adjacent conductive flakes is maintained.

The durometer rating of the electrically conductive elastomer material 302 typically ranges between 40 and 80 on the Shore A scale. Such a durometer rating allows the electrically conductive elastomer material 302 to be expanded or compressed to at least 33% of its at-rest shape. When such a deformation occurs, the conductive flakes interspersed in the electrically conductive elastomer material 22 interact as described above so as to maintain a low resistivity throughout the electrically conductive elastomer material 22. An electrically conductive elastomer material that has been grafted to electrically conductive contact pads on a circuit board in accordance with the present invention has been shown to maintain a resistance in the range of 20-30 mohms during measurements performed while deforming the electrically conductive elastomer material 302 within the above-described limits.

At this point it should be noted that although the electrically conductive elastomer material 302 has been shown above to be useful in facilitating the making of electrical connections between electrically conductive contact pads on a circuit board and electrically conductive contact points on a semiconductor die, the electrically conductive elastomer material 302 can also be used to facilitate the making of electrical connections between electrically conductive contact pads on a circuit board and electrically conductive terminals on leaded or leadless integrated circuits. Furthermore, the electrically conductive elastomer material 302 can be grafted to flexible metal materials which are used in flex film circuits and the like.

At this point it should be noted that it is possible to add further materials to the electrically conductive elastomer material mixture in order to further facilitate in the making of electrical connections between the electrically conductive elastomer material 302 and any mating electrically conductive surface.

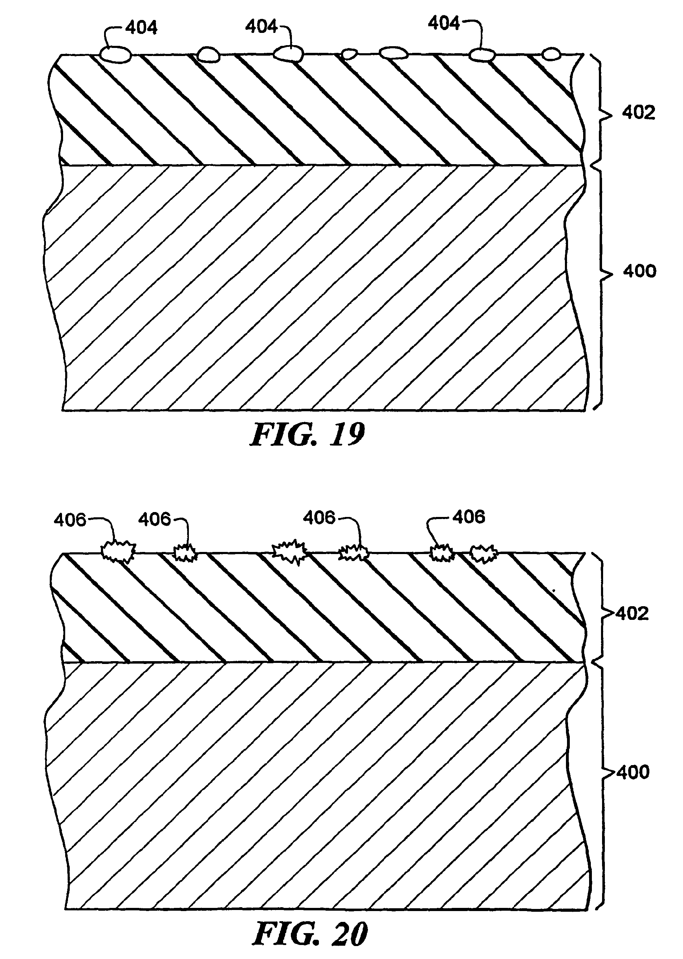

Referring to Figure 19, there is shown a cross-sectional view of a noble metal or noble metal composite material substrate 400 having an electrically conductive elastomer material 402 grafted thereto. In accordance with the present invention as described above, the electrically conductive elastomer material 402 comprises a mixture of an elastic material, a quantity of electrically conductive flakes, a thermoplastic elastomer material, a conductive thermoplastic polymer material, and a noble metal or noble metal composite material. Also in accordance with the present invention as described above, since both the noble metal or noble metal composite material substrate 400 and the noble metal or noble metal composite material in the electrically conductive elastomer material 402 are in fact both noble metal or noble metal composite materials, a strong chemical bond will form between the electrically conductive elastomer material 402 and the noble metal or noble metal composite material substrate 400 when the electrically conductive elastomer material 402 is grafted to the noble metal or noble metal composite material substrate 400.

In order to further facilitate in the making of electrical connections between the electrically conductive elastomer material 402 and any mating electrically conductive surface, the electrically conductive elastomer material 402 may further comprise a quantity of electrically conductive indenting particles 404 that are imbedded into the surface of the electrically conductive elastomer material 402. The conductive indenting particles 404 are preferably applied to the surface of the electrically conductive elastomer material 402 prior to a thermal cycle so that the particles 404 are secured to the electrically conductive elastomer material 402 when it fully cures. The indenting nature of the conductive indenting particles 404 provides a means by which an insulating oxide which may have formed on an electrically conductive surface which is to come into contact with the electrically conductive elastomer material 402 may be pushed aside so that an improved electrical connection may be formed between that electrically conductive surface and the electrically conductive elastomer material 402. It should be noted that the conductive indenting particles 404 may push aside other contaminants such as fibers and particulates which may be present on a mating conductive surface.

The conductive indenting particles 404 may be fabricated of many different types of conductive or semiconductive materials such as, for example, silver, nickel, or carbon. Alternatively, the conductive indenting particles 404 may be fabricated of many different types of conductive, semiconductive, or insulative materials which are coated with or have interspersed therein other conductive or semiconductive materials such as, for example, silver, nickel, or carbon. The conductive indenting particles 404 typically have a 50 µm average particle size.

Referring to Figure 20, there is shown a cross-sectional view of the noble metal or noble metal composite material substrate 400 having the electrically conductive elastomer material 402 grafted thereto. In order to further facilitate in the making of electrical connections between the electrically conductive elastomer material 402 and any mating electrically conductive surface, the electrically conductive elastomer material 402 may further comprise a quantity of electrically conductive piercing particles 406 that are imbedded into the surface of the electrically conductive elastomer material 402. The conductive piercing particles 406 are preferably applied to the surface of the electrically conductive elastomer material 402 prior to a thermal cycle so that the particles 406 are secured to the electrically conductive elastomer material 402 when it fully cures. The piercing nature of the conductive piercing particles 406 provides a means by which an insulating oxide which may have formed on an electrically conductive surface which is to come into contact with the electrically conductive elastomer material 402 may be pierced so that an improved electrical connection may be formed between that electrically conductive surface and the electrically conductive elastomer material 402. It should be noted that the conductive piercing particles 406 may pierce other contaminants such as fibers and particulates which may be present on a mating conductive surface.

The conductive piercing particles 406 may be fabricated of many different types of conductive or semiconductive materials such as, for example, silver, nickel, or carbon. Alternatively, the conductive piercing particles 406 may be fabricated of many different types of conductive, semiconductive, or insulative materials which are coated with or have interspersed therein other conductive or semiconductive materials such as, for example, silver, nickel, or carbon. The conductive piercing particles 406 typically have a 40 µm average particle size.

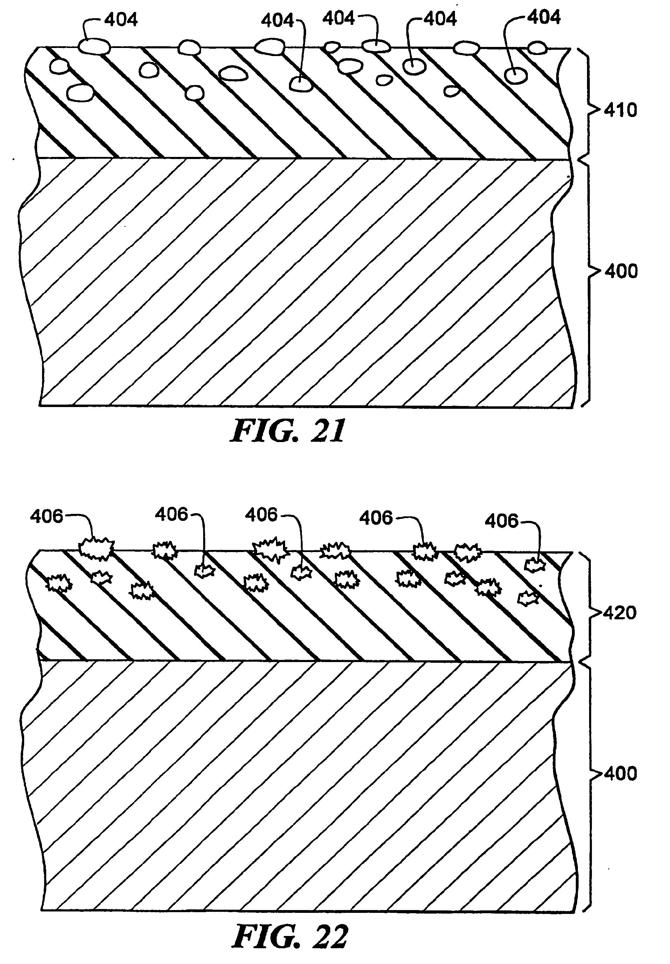

Referring to Figure 21, there is shown a cross-sectional view of the noble metal or noble metal composite material substrate 400 having an electrically conductive elastomer material 410 grafted thereto. In this particular embodiment, the electrically conductive elastomer material 410 comprises a mixture of an elastic material, a quantity of electrically conductive flakes, a thermoplastic elastomer material, a conductive thermoplastic polymer material, a noble metal or noble metal composite material, and a quantity of the electrically conductive indenting particles 404 (only the indenting particles are shown for purposes of figure clarity). That is, the conductive indenting particles 404 are deposited on the substrate 400 along with the rest of the materials in the electrically conductive elastomer material 410.

The distribution of the conductive indenting particles 404 in the electrically conductive elastomer material 410 is shown to be near the surface of the electrically conductive elastomer material 410 since the conductive indenting particles 404 are likely to bounce off the substrate 400 during the application of the electrically conductive elastomer material 410. That is, when the electrically conductive elastomer material 410 is applied to the substrate 400 by spray coating, the conductive indenting particles 404 are likely to bounce off the substrate 400. Of course, this location for the conductive indenting particles 404 is preferable based on their functionality (e.g., to push aside oxide on a mating conductive surface). The amount of the conductive indenting particles 404 in the electrically conductive elastomer material 410 need typically only be 5% nominal by weight in order to insure their proper functionality.

Referring to Figure 22, there is shown a cross-sectional view of the noble metal or noble metal composite material substrate 400 having an electrically conductive elastomer material 420 grafted thereto. In this particular embodiment, the electrically conductive elastomer material 420 comprises a mixture of an elastic material, a quantity of electrically conductive flakes, a thermoplastic elastomer material, a conductive thermoplastic polymer material, a noble metal or noble metal composite material, and a quantity of the electrically conductive indenting particles 406 (only the piercing particles are shown for purposes of figure clarity). That is, the conductive piercing particles 406 are deposited on the substrate 400 along with the rest of the materials in the electrically conductive elastomer material 420.

The distribution of the conductive piercing particles 406 in the electrically conductive elastomer material 420 is shown to be near the surface of the electrically conductive elastomer material 420 since the conductive piercing particles 406 are likely to bounce off the substrate 400 during the application of the electrically conductive elastomer material 420. That is, when the electrically conductive elastomer material 420 is applied to the substrate 400 by spray coating, the conductive piercing particles 406 are likely to bounce off the substrate 400. Of course, this location for the conductive piercing particles 406 is preferable based on their functionality (e.g., to pierce oxide on a mating conductive surface). The amount of the conductive piercing particles 406 in the electrically conductive elastomer material 420 need typically only be 5% nominal by weight in order to insure their proper functionality.

At this point it should be noted that any of the above-described electrically conductive elastomer materials, including those with electrically conductive piercing and indenting particles, may be utilized for any number of applications wherein an electrically conductive surface, trace, coating, or other electrically conductive element having elastic properties is required.

The present invention is not to be limited in scope by the specific embodiments described herein. Indeed, various modifications of the present invention, in addition to those described herein, will be apparent to those of skill in the art from the foregoing description and accompanying drawings. Thus, the scope of the invention is defined by the appended claims.

## Claims

1. An elastic circuit comprising:
a substrate (66) having an outer surface, said substrate being formed of a non-conductive elastic material; and
a conductive elastomer (68) thermally grafted directly to at least a portion of said outer surface of said substrate (66), said conductive elastomer (68) having an outer surface and being formed of a non-conductive elastic material (20) having a quantity of conductive flakes (22) interspersed in said elastomer, and a quantity of conductive particles (70, 72) either interspersed in the non-conductive elastic material (20) such that at least some of the conductive particles (70, 72) are present along the outer surface of the conductive elastomer (68), or imbedded in the outer surface of the conductive elastomer (68) such that at least a portion of the conductive particles (70, 72) extends beyond the outer surface of the conductive elastomer (68).

2. The elastic circuit as defined in claim 1, wherein the grafting of said conductive elastomer (68) to said substrate (66) is further performed by irradiation.

3. The elastic circuit as defined in claim 1, wherein the grafting of said conductive elastomer (68) to said substrate (66) is further performed by compression.

4. The elastic circuit as defined in claim 1, wherein said conductive flakes(22) are formed of a solid conductive material.

5. The elastic circuit as defined in claim 1, wherein said conductive flakes (22) are formed of a semi-conductive material that is coated with a conductive material.

6. The elastic circuit as defined in claim 1, wherein said conductive flakes (22) are formed of a non-conductive material that is coated with a conductive material.

7. The elastic circuit as defined in claim 1, wherein said conductive particles (70) have a rounded outer surface so as to push aside any oxide or other contaminants which may have formed on a mating conductive surface when said elastic circuit is coupled to the mating conductive surface.

8. The elastic circuit as defined in claim 7 wherein said rounded conductive particles have a 50 µm average particle size.

9. The elastic circuit as defined in claim 1, wherein said conductive particles (72) have a jagged outer surface so as to pierce through any oxide or other contaminants which may have formed on a mating conductive surface when said elastic circuit is coupled to the mating conductive surface.

10. The elastic circuit as defined in claim 9 wherein said jagged conductive particles have a 40 µm average particle size.

11. The elastic circuit as defined in claim 1, wherein said conductive particles (70, 72) are formed of a solid conductive material.

12. The elastic circuit as defined in claim 1, wherein said conductive particles (70, 72) are formed of a semi-conductive material that is coated with a conductive material.

13. The elastic circuit as defined in claim 1, wherein said conductive particles (70, 72) are formed of a non-conductive material that is coated with a conductive material.

14. The elastic circuit as defined in claim 1 wherein said circuit comprises a circuit board, wherein said substrate (66) is formed of a non-conductive thermoset material, and wherein said conductive elastomer (68) further includes a thermoplastic elastomer material and a thermoset material.

15. The elastic circuit as defined in claim 1 wherein said circuit comprises a flex film circuit, wherein said substrate (66) is formed of a non-conductive thermoplastic material, and wherein said conductive elastomer (68) further includes a thermoplastic elastomer material and a thermoplastic material.

16. The circuit of claim 1 wherein said circuit comprises an electrical interconnect system wherein said substrate (66) is formed of a conductive metal material, and wherein said conductive elastomer (68) further comprises a thermoplastic elastomer material, a conductive thermoplastic polymer material, and a conductive metal material.

17. The circuit as defined in claim 16, wherein said conductive thermoplastic polymer material is a conductive thermoplastic polymer chain comprising a thermoplastic material chain core with a conductive material at the ends of at least some branches which extend off of said thermoplastic material chain core.

18. A method for grafting a conductive elastomer (68) to an elastic substrate (66), said method comprising the steps of:
providing a substrate (66), said substrate (66) having an outer surface, said substrate (66) being formed of a non-conductive elastic material;
applying a conductive elastomer (68) to said outer surface of said substrate (66), said conductive elastomer (68) having an outer surface and being formed of a non-conductive elastic material (20) having a quantity of conductive flakes(22) interspersed in said elastomer (68), and a quantity of conductive particles (70, 72) either interspersed in the non-conductive elastic material (20) such that at least some of the conductive particles (70, 72) are present along the outer surface of the conductive elastomer (68), or applied to the outer surface of the conductive elastomer (68);
subjecting said substrate (66) and said conductive elastomer(68) to a thermal process so that polymer chains in said non-conductive elastic material(20) of said conductive elastomer (68) are grafted to polymer chains in said non-conductive elastic material (20) of said substrate (66);
such that at least some of the conductive particles (70, 72) applied to the outer surface of the conductive elastomer (68) become imbedded in the outer surface of the conductive elastomer (68) and at least a portion of the conductive particles (70, 72) extends beyond the outer surface of the conductive elastomer (68) after subjecting said substrate (66) and said conductive elastomer (68) to said thermal process.

19. A method for grafting a conductive elastomer (68) to a thermoset or thermoplastic substrate (66), said method comprising the steps of:
providing a substrate (66), said substrate (66) having an outer surface, said substrate (66) being formed of a non-conductive thermoset or thermoplastic material;
applying a conductive elastomer (68) to said outer surface of said substrate (66), said conductive elastomer (68) having an outer surface and being formed of a mixture of a non-conductive elastic material, a quantity of conductive flakes (22), a thermoplastic elastomer material, a thermoset or thermoplastic material, and a quantity of conductive particles (70, 72) either interspersed in the mixture such that at least some of the conductive particles (70, 72) are present along the outer surface of the conductive elastomer (68), or applied to the outer surface of the conductive elastomer (68); and
subjecting said substrate (66) and said conductive elastomer (68) to a thermal process so that polymer chains in said conductive elastomer (68) are grafted to polymer chains in said substrate (66);
such that at least some of the conductive particles (70, 72) applied to the outer surface of the conductive elastomer (68) become imbedded in the outer surface of the conductive elastomer (68) and at least a portion of the conductive particles (70, 72) extends beyond the outer surface of the conductive elastomer (68) after subjecting said substrate (66) and said conductive elastomer (68) to said thermal process.

20. A method for grafting a conductive elastomer (68) to a metal substrate (66), said method comprising the steps of:
providing a substrate (66), said substrate (66) having an outer surface, said substrate (66) being formed of a conductive noble metal material;
applying a conductive elastomer (68) to said outer surface of said substrate (66), said conductive elastomer (68) having an outer surface and being formed of a mixture of a non-conductive elastic material, a quantity of conductive flakes (20), a thermoplastic elastomer material, a conductive thermoplastic polymer material, a conductive metal material, and a quantity of conductive particles (70, 72) either interspersed in the non-conductive elastic material such that at least some of the conductive particles (70, 72) are present along the outer surface of the conductive elastomer (68), or applied to the outer surface of the conductive elastomer (68); and
subjecting said substrate (66) and said conductive elastomer (68) to a thermal process so that polymer chains in said conductive elastomer (68) are grafted to polymer chains in said substrate (66);
such that at least some of the conductive particles (70, 72) applied to the outer surface of the conductive elastomer (68) become imbedded in the outer surface of the conductive elastomer (68) and at least a portion of the conductive particles (70, 72) extends beyond the outer surface of the conductive elastomer (68) after subjecting said substrate (66) and said conductive elastomer (68) to said thermal process.

## Patentansprüche

1. Eine elastische Schaltung umfassend:
ein Substrat (66) mit einer äußeren Oberfläche, wobei das Substrat aus einem nicht-leitfähigen elastischen Material gebildet ist; und
ein leitfähiges Elastomer (68), das thermisch direkt auf zumindest einen Teil der äußeren Oberfläche des Substrats (66) aufgepfropft ist, wobei das leitfähige Elastomer (68) eine äußere Oberfläche besitzt und aus einem nicht-leitfähigen elastischen Material (20), das mit einer Menge leitfähiger Flocken (22) in dem Elastomer durchsetzt ist, und einer Menge leitfähiger Partikel (70, 72), mit dem entweder das nicht leitfähige elastische Material (20) so durchsetzt ist, dass zumindest einige der leitfähigen Partikel (70, 72) entlang der äußeren Oberfläche des leitfähigen Elastomers (68) vorliegen, oder die in der äußeren Oberfläche des leitfähigen Elastomers (68) so eingebettet sind, dass sich zumindest ein Teil der leitfähigen Partikel (70, 72) über die äußere Oberfläche des leitfähigen Elastomers (68) erstreckt, gebildet ist.

2. Die elastische Schaltung gemäß Anspruch 1, wobei das Aufpfropfen des leitfähigen Elastomers (68) auf das Substrat (66) des weiteren mittels Bestrahlung erfolgt.

3. Die elastische Schaltung gemäß Anspruch 1, wobei das Aufpfropfen des leitfähigen Elastomers (68) auf das Substrat (66) des weiteren durch Kompression erfolgt.

4. Die elastische Schaltung gemäß Anspruch 1, wobei die leitfähigen Flocken (22) aus einem festen leitfähigen Material gebildet sind.

5. Die elastische Schaltung gemäß Anspruch 1, wobei die leitfähigen Flocken (22) aus einem semi-leitfähigen Material gebildet sind, das mit einem leitfähigen Material beschichtet ist.

6. Die elastische Schaltung gemäß Anspruch 1, wobei die leitfähigen Flocken (22) aus einem nicht-leitfähigen Material gebildet sind, das mit einem leitfähigen Material beschichtet ist.

7. Die elastische Schaltung gemäß Anspruch 1, wobei die leitfähigen Partikel (70) eine gerundete äußere Oberfläche besitzen, um etwaige Oxide oder andere Fremdkörper, die sich auf einer leitfähigen Kontaktoberfläche ausgebildet haben könnten, zur Seite zu schieben, wenn die elastische Schaltung mit der leitfähigen Kontaktoberfläche gekoppelt wird.

8. Die elastische Schaltung gemäß Anspruch 7, wobei die abgerundeten leitfähigen Partikel eine durchschnittliche Partikelgröße von 50 µm besitzen.

9. Die elastische Schaltung gemäß Anspruch 1, wobei die leitfähigen Partikel (72) eine zackige äußere Oberfläche besitzen, um etwaige Oxide oder andere Fremdstoffe, die sich auf einer leitfähigen Kontaktoberfläche ausgebildet haben könnten, zu durchdringen, wenn die elastische Schaltung mit der leitfähigen Kontaktoberfläche gekoppelt wird.

10. Die elastische Schaltung gemäß Anspruch 9, wobei die zackigen leitfähigen Partikel eine durchschnittliche Partikelgröße von 40 µm besitzen.

11. Die elastische Schaltung gemäß Anspruch 1, wobei die leitfähigen Partikel (70, 72) aus einem festen leitfähigen Material gebildet sind.

12. Die elastische Schaltung gemäß Anspruch 1, wobei die leitfähigen Partikel (70, 72) aus einem semi-leitfähigen Material gebildet sind, das mit einem leitfähigen Material beschichtet ist.

13. Die elastische Schaltung gemäß Anspruch 1, wobei die leitfähigen Partikel (70, 72) aus einem nicht-leitfähigen Material gebildet sind, das mit einem leitfähigen Material beschichtet ist.

14. Die elastische Schaltung gemäß Anspruch 1, wobei die Schaltung eine Platine umfasst, wobei das Substrat (66) aus einem nicht-leitfähigen duroplastischen Material gebildet ist, und wobei das leitfähige Elastomer (68) des weiteren ein thermoplastisches Elastomermaterial und ein Duroplastmaterial aufweist.

15. Die elastische Schaltung gemäß Anspruch 1, wobei die Schaltung einen flexiblen Schichtschaltkreis umfasst, wobei das Substrat (66) aus einem nicht-leitfähigen thermoplastischen Material gebildet ist, und wobei das leitfähige Elastomer (68) des weiteren ein thermoplastisches Elastomermaterial und ein thermoplastisches Material aufweist.

16. Die Schaltung gemäß Anspruch 1, wobei die Schaltung ein elektrisches Verbindungssystem umfasst, wobei das Substrat (66) aus einem leitfähigen Metallmaterial gebildet ist und wobei das leitfähige Elastomer (68) des weiteren ein thermoplastisches Elastomermaterial, ein leitfähiges thermoplastisches Polymermaterial und ein leitfähiges Metallmaterial umfasst.

17. Die Schaltung gemäß Anspruch 16, wobei das leitfähige thermoplastische Polymermaterial eine leitfähige thermoplastische Polymerkette ist, die einen thermoplastischen Materialkettenkern umfasst mit einem leitfähigen Material an den Enden von zumindest einige Zweigen, die sich von dem thermoplastischen Materialkettenkern weg erstrecken.

18. Ein Verfahren zum Pfropfen eines leitfähigen Elastomers (68) auf ein elastisches Substrat (66), wobei das Verfahren die Schritte umfasst:
Zurverfügungstellen eines Substrats (66), wobei das Substrat (66) eine äußere Oberfläche besitzt und aus einem nicht-leitfähigen elastischen Material gebildet ist;
Aufbringen eines leitfähigen Elastomers (68) auf die äußere Oberfläche des Substrats (66), wobei das leitfähige Elastomer (68) eine äußere Oberfläche besitzt und aus einem nicht-leitfähigen elastischen Material (20), das mit einer Menge leitfähiger Flocken (22) in dem Elastomer (68) durchsetzt ist, und einer Menge leitfähiger Partikel (70, 72), die entweder das nicht-leitfähige elastische Material (20) derart durchsetzen, dass zumindest einige der leitfähigen Partikel (70, 72) entlang der äußeren Oberfläche des leitfähigen Elastomers (68) vorliegen, oder die auf die äußere Oberfläche des leitfähigen Elastomers (68) aufgebracht werden, gebildet wird;
Aussetzen des Substrats (66) und des leitfähigen Elastomers (68) einem thermischen Prozess, so dass Polymerketten in dem nicht-leitfähigen elastischen Material (20) des leitfähigen Elastomers (68) auf Polymerketten in dem nicht-leitfähigen elastischen Material (20) des Substrats (66) aufgepfropft werden;
so dass zumindest einige der auf die äußere Oberfläche des leitfähigen Elastomers (68) aufgebrachten leitfähigen Partikel (70, 72) in der äußeren Oberfläche des leitfähigen Elastomers (68) eingebettet werden und sich zumindest ein Teil der leitfähigen Partikel (70, 72) über die äußere Oberfläche des leitfähigen Elastomers (68) erstrecken, nachdem das Substrat (66) und das leitfähige Elastomer (68) dem thermischen Prozess ausgesetzt worden sind.

19. Ein Verfahren zum Pfropfen eines leitfähigen Elastomers (68) auf ein duroplastisches oder thermoplastisches Substrat (66), wobei das Verfahren die Schritte umfasst:
Zurverfügungstellen eines Substrats (66), wobei das Substrat (66) eine äußere Oberfläche besitzt und aus einem nicht-leitfähigen duroplastischen oder thermoplastischen Material gebildet ist;
Aufbringen eines leitfähigen Elastomers (68) auf die äußere Oberfläche des Substrats (66), wobei das leitfähige Elastomer (68) eine äußere Oberfläche besitzt und aus einer Mischung aus einem nicht-leitfähigen elastischen Material, einer Menge leitfähiger Flocken (22), einem thermoplastischen Elastomermaterial, einem duroplastischen oder thermoplastischen Material und einer Menge leitfähiger Partikel (70, 72), mit der die Mischung entweder so durchsetzt ist, dass zumindest einige der leitfähigen Partikel (70, 72) entlang der äußeren Oberfläche des leitfähigen Elastomers (68) vorliegen, oder die auf die äußere Oberfläche des leitfähigen Elastomers (68) aufgebracht werden, gebildet wird; und
Aussetzen des Substrats (66) und des leitfähigen Elastomers (68) einem thermischen Prozess, so dass Polymerketten in dem leitfähigen Elastomer (68) auf Polymerketten in dem Substrat (66) aufgepfropft werden;
so, dass zumindest einige der auf die äußere Oberfläche des leitfähigen Elastomers (68) aufgebrachten leitfähigen Partikel (70, 72) in der äußeren Oberfläche des leitfähigen Elastomers (68) eingebettet werden und sich zumindest ein Teil der leitfähigen Partikel (70, 72) über die äußere Oberfläche des leitfähigen Elastomers (68) erstrecken, nachdem das Substrat (66) und das leitfähige Elastomer (68) dem thermischen Prozess ausgesetzt worden sind.

20. Ein Verfahren zum Pfropfen eines leitfähigen Elastomers (68) auf ein metallisches Substrat (66), wobei das Verfahren die Schritte umfasst:
Zurverfügungstellen eines Substrats (66), wobei das Substrat (66) eine äußere Oberfläche besitzt und aus einem leitfähigen Edelmetallmaterial gebildet ist;
Aufbringen eines leitfähigen Elastomers (68) auf die äußere Oberfläche des Substrats (66), wobei das leitfähige Elastomer (68) eine äußere Oberfläche besitzt und aus einer Mischung aus einem nicht-leitfähigen elastischen Material, einer Menge leitfähiger Flocken (20), einem thermoplastischen Elastomermaterial, einem leitfähigen thermoplastischen Polymermaterial, einem leitfähigen metallischen Material und einer Menge leitfähiger Partikel (70, 72), mit der das nicht-leitfähige elastische Material entweder so durchsetzt ist, dass zumindest einige der leitfähigen Partikel (70, 72) entlang der äußeren Oberfläche des leitfähigen Elastomers (68) vorliegen, oder die auf die äußere Oberfläche des leitfähigen Elastomers (68) aufgebracht werden, gebildet wird; und
Aussetzen des Substrats (66) und des leitfähigen Elastomers (68) einem thermischen Prozess, so dass Polymerketten in dem leitfähigen Elastomer (68) auf Polymerketten in dem Substrat (66) aufgepfropft werden;
so dass zumindest einige der auf die äußere Oberfläche des leitfähigen Elastomers (68) aufgebrachten leitfähigen Partikels (70, 72) in der äußeren Oberfläche des leitfähigen Elastomers (68) eingebettet werden und sich zumindest ein Teil der leitfähigen Partikel (70, 72) über die äußere Oberfläche des leitfähigen Elastomers (68) erstrecken, nachdem das Substrat (66) und das leitfähige Elastomer (68) dem thermischen Prozess ausgesetzt worden sind.

## Revendications

1. Circuit élastique comprenant :
un substrat (66) présentant une surface extérieure, ledit substrat étant formé d'un matériau élastique non conducteur ; et
un élastomère conducteur (68) thermiquement greffé directement sur au moins une partie de ladite surface extérieure dudit substrat (66), ledit élastomère conducteur (68) présentant une surface extérieure et étant formé d'un matériau élastique non conducteur (20) ayant une quantité d'écailles conductrices (22) parsemées dans ledit élastomère, et une quantité de particules conductrices (70, 72) parsemées dans le matériau élastique non conducteur (20) de sorte qu'au moins certaines des particules conductrices (70, 72) soient présentes le long de la surface extérieure de l'élastomère conducteur (68), ou incorporées dans la surface extérieure de l'élastomère conducteur (68) de sorte qu'au moins une partie des particules conductrices (70, 72) s'étendent au-delà de la surface extérieure de l'élastomère conducteur (68).

2. Circuit élastique selon la revendication 1, dans lequel la greffe dudit élastomère conducteur (68) sur ledit substrat (66) est en outre effectuée par irradiation

3. Circuit élastique selon la revendication 1, dans lequel la greffe dudit élastomère conducteur (68) sur ledit substrat (66) est en outre effectuée par compression.

4. Circuit élastique selon la revendication 1, dans lequel lesdites écailles conductrices (22) sont formées d'un matériau conducteur solide.

5. Circuit élastique selon la revendication 1, dans lequel lesdites écailles conductrices (22) sont formées d'un matériau semi-conducteur qui est recouvert d'un matériau conducteur.

6. Circuit élastique selon la revendication 1, dans lequel lesdites écailles conductrices (22) sont formées d'un matériau non conducteur qui est recouvert d'un matériau conducteur.

7. Circuit élastique selon la revendication 1, dans lequel lesdites particules conductrices (70) présentent une surface extérieure arrondie de manière à pousser tout oxyde ou autres agents de contamination qui peuvent s'être formés sur une surface conductrice correspondante lorsque ledit circuit élastique est couplé à la surface conductrice correspondante.

8. Circuit élastique selon la revendication 7, dans lequel lesdites particules conductrices arrondies ont une taille de particule moyenne de 50 µm.

9. Circuit élastique selon la revendication 1, dans lequel lesdites particules conductrices (72) ont une surface extérieure déchiquetée de manière à percer tout oxyde ou autres agent de contamination qui peuvent s'être formés sur une surface conductrice correspondante lorsque ledit circuit élastique est couplé à la surface conductrice correspondante.

10. Circuit élastique selon la revendication 9, dans lequel lesdites particules conductrices déchiquetées ont une taille de particule moyenne de 40 µm.

11. Circuit élastique selon la revendication 1, dans lequel lesdites particules conductrices (70, 72) sont formées d'un matériau conducteur solide.

12. Circuit élastique selon la revendication 1, dans lequel lesdites particules conductrices (70, 72) sont formées d'un matériau semi-conducteur qui est recouvert d'un matériau conducteur.

13. Circuit élastique selon la revendication 1, dans lequel lesdites particules conductrices (70, 72) sont formées d'un matériau non conducteur qui est recouvert d'un matériau conducteur.

14. Circuit élastique selon la revendication 1, dans lequel ledit circuit comprend une carte de circuit, dans lequel ledit substrat (66) est formé d'un matériau thermodurci non conducteur, et dans lequel ledit élastomère conducteur (68) comprend en outre un matériau élastomère thermoplastique et un matériau thermodurci.

15. Circuit élastique selon la revendication 1, dans lequel ledit circuit comprend un circuit à film flexible, dans lequel ledit substrat (66) est formé d'un matériau thermoplastique non conducteur, et dans lequel ledit élastomère conducteur (68) comprend en outre un matériau élastomère thermoplastique et un matériau thermoplastique.

16. Circuit selon la revendication 1, dans lequel ledit circuit comprend un système d'interconnexion électrique, dans lequel ledit substrat (66) est formé d'un matériau métallique conducteur, et dans lequel ledit élastomère conducteur (68) comprend en outre un matériau élastomère thermoplastique, un matériau polymère thermoplastique conducteur et un matériau métallique conducteur.

17. Circuit selon la revendication 16, dans lequel ledit matériau polymère thermoplastique conducteur est une chaîne polymère thermoplastique conductrice comprenant un noyau de chaîne de matériau thermoplastique avec un matériau conducteur aux extrémités d'au moins certaines branches qui s'étendent hors dudit noyau de chaîne de matériau thermoplastique.

18. Procédé de greffe d'un élastomère conducteur (68) sur un substrat élastique (66), ledit procédé comprenant les étapes consistant à :
prévoir un substrat (66), ledit substrat (66) ayant une surface extérieure, ledit substrat (66) étant formé d'un matériau élastique non conducteur ;
appliquer un élastomère conducteur (68) sur ladite surface extérieure dudit substrat (66), ledit élastomère conducteur (68) présentant une surface extérieure et étant formé d'un matériau élastique non conducteur (20) ayant une quantité d'écailles conductrices (22) parsemées dans ledit élastomère (68), et une quantité de particules conductrices (70, 72) parsemées dans le matériau élastique non conducteur (20) de sorte qu'au moins certaines des particules conductrices (70, 72) soient présentes le long de la surface extérieure de l'élastomère conducteur (68), ou appliquées à la surface extérieure de l'élastomère conducteur (68) ;
soumettre ledit substrat (66) et ledit élastomère conducteur (68) à un processus thermique de sorte que les chaînes polymères dans ledit matériau élastique non conducteur (20) dudit élastomère conducteur (68) soient greffées aux chaînes polymères dans ledit matériau élastique non conducteur (20) dudit substrat (66) ;
de sorte qu'au moins certaines des particules conductrices (70, 72) appliquées à la surface extérieure de l'élastomère conducteur (68) s'incorporent dans la surface extérieure de l'élastomère conducteur (68) et qu'au moins une partie des particules conductrices (70, 72) s'étende au-delà de la surface extérieure de l'élastomère conducteur (68) après avoir soumis ledit substrat (66) et ledit élastomère conducteur (68) audit processus thermique.

19. Procédé de greffe d'un élastomère conducteur (68) à un substrat thermodurci ou thermoplastique (66), ledit procédé comprenant les étapes consistant à :
prévoir un substrat (66), ledit substrat (66) ayant une surface extérieure, ledit substrat (66) étant formé d'un matériau thermodurci ou thermoplastique non conducteur ;
appliquer un élastomère conducteur (68) sur ladite surface extérieure dudit substrat (66), ledit élastomère conducteur (68) présentant une surface extérieure et étant formé d'un mélange d'un matériau élastique non conducteur, d'une quantité d'écailles conductrices (22), d'un matériau élastomère thermoplastique, d'un matériau thermodurci ou thermoplastique et d'une quantité de particules conductrices (70, 72) parsemées dans le mélange de sorte qu'au moins certaines des particules conductrices (70, 72) soient présentes le long de la surface extérieure de l'élastomère conducteur (68), ou appliquées à la surface extérieure de l'élastomère conducteur (68) ; et
soumettre ledit substrat (66) et ledit élastomère conducteur (68) à un processus thermique de sorte que les chaînes polymères dans ledit élastomère conducteur (68) soient greffées aux chaînes polymères dans ledit substrat (66) ;
de sorte qu'au moins certaines des particules conductrices (70, 72) appliquées à la surface extérieure de l'élastomère conducteur (68) s'incorporent dans la surface extérieure de l'élastomère conducteur (68) et qu'au moins une partie des particules conductrices (70, 72) s'étende au-delà de la surface extérieure de l'élastomère conducteur (68) après avoir soumis ledit substrat (66) et ledit élastomère conducteur (68) audit processus thermique.

20. Procédé de greffe d'un élastomère conducteur (68) à un substrat métallique (66), ledit procédé comprenant les étapes consistant à :
prévoir un substrat (66), ledit substrat (66) ayant une surface extérieure, ledit substrat (66) étant formé d'un matériau métallique noble conducteur ;
appliquer un élastomère conducteur (68) sur ladite surface extérieure dudit substrat (66), ledit élastomère conducteur (68) présentant une surface extérieure et étant formé d'un mélange d'un matériau élastique non conducteur, d'une quantité d'écailles conductrices (20), d'un matériau élastomère thermoplastique, d'un matériau polymère thermoplastique conducteur, d'un matériau métallique conducteur et d'une quantité de particules conductrices (70, 72) parsemées dans le matériau élastique non conducteur de sorte qu'au moins certaines des particules conductrices (70, 72) soient présentes le long de la surface extérieure de l'élastomère conducteur (68), ou appliquées à la surface extérieure de l'élastomère conducteur (68) ; et
soumettre ledit substrat (66) et ledit élastomère conducteur (68) à un processus thermique de sorte que les chaînes polymères dans ledit élastomère conducteur (68) soient greffées aux chaînes polymères dans ledit substrat (66) ;
de sorte qu'au moins certaines des particules conductrices (70, 72) appliquées à la surface extérieure de l'élastomère conducteur (68) s'incorporent dans la surface extérieure de l'élastomère conducteur (68) et qu'au moins une partie des particules conductrices (70, 72) s'étende au-delà de la surface extérieure de l'élastomère conducteur (68) après avoir soumis ledit substrat (66) et ledit élastomère conducteur (68) audit processus thermique.
